# FASCICULE DE BREVET EUROPEEN

(11) **EP 4 335 034 B1**
(45) Date de publication et mention de la délivrance du brevet: **23.07.2025**
(21) Numéro de dépôt: 21769159.1
(22) Date de dépôt: 07.05.2021
(51) Int. Cl.: H03M 13/29, H03M 13/39, H03M 13/00

(54) **DECODAGE DE TURBO CODES CONCATENES EN SERIE**
DEKODIERUNG VON SERIELL VERKETTETEN TURBO CODES
DECODING OF SERIALLY CONCATENATED TURBO CODES

(43) Date de publication de la demande: 13.03.2024
(73) Titulaire: Safran Data Systems, 91978 Courtaboeuf Cedex (FR)
(72) Inventeur: BOURENANE, Aomar, 77550 MOISSY-CRAMAYEL (FR); GUILLOUD, Frédéric, 91120 PALAISEAU (FR); ARZEL, Matthieu, 91120 PALAISEAU (FR)
(74) Mandataire: Regimbeau
(86) Numéro de dépôt international: PCT/FR2021/050788
(87) Numéro de publication internationale: WO 2022/234196

(56) Documents cités:
- LU Y-C ET AL: "Concurrent Algorithm and Hardware Implementation for Low-Latency Turbo Decoder Using a Single MAP Decoder", IEICE TRANSACTION ON COMMUNICATION, COMMUNICATIONS SOCIETY, TOKYO, JP, vol. E93B, no. 1, 1 January 2010 (2010-01-01), pages 1 - 8, XP001552479, ISSN: 0916-8516, DOI: 10.1587/TRANSCOM.E93.B.1
- SALIM HADDAD ET AL: "Complexity reduction of shuffled parallel iterative demodulation with turbo decoding", TELECOMMUNICATIONS (ICT), 2012 19TH INTERNATIONAL CONFERENCE ON, IEEE, 23 April 2012 (2012-04-23), pages 1 - 6, XP032188356, ISBN: 978-1-4673-0745-1, DOI: 10.1109/ICTEL.2012.6221298
- AMBROZE A ET AL: "Iterative MAP decoding for serial concatenated convolutional codes", IEE PROCEEDINGS : COMMUNICATIONS, INSTITUTION OF ELECTRICAL ENGINEERS, GB, vol. 145, no. 2, 16 April 1998 (1998-04-16), pages 53 - 59, XP006010890, ISSN: 1350-2425, DOI: 10.1049/IP-COM:19981876

## Description

### DOMAINE DE L'INVENTION

La présente invention concerne le domaine des télécommunications numériques et plus précisément le domaine du codage de canal, et en particulier les procédés de décodage de codes convolutifs concaténés en série. Le codage de canal consiste à utiliser des codes correcteurs d'erreurs qui augmentent le niveau de redondance de l'information transmise, pour permettre une meilleure restitution de l'information initiale à la réception malgré les erreurs introduites lors de la corruption de ce message par sa transmission à travers un canal de propagation.

### ETAT DE LA TECHNIQUE

### Turbo-codes parallèles, turbo-codes produit

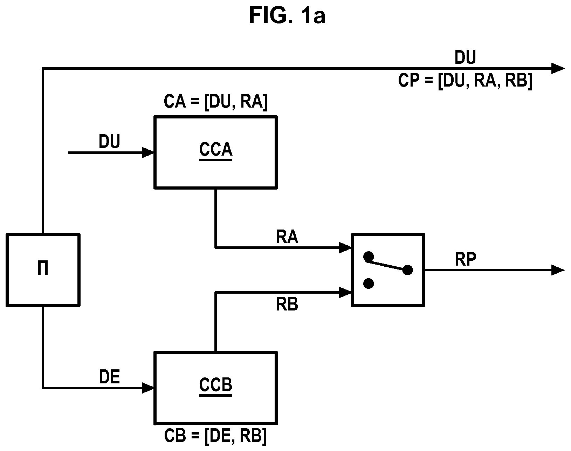

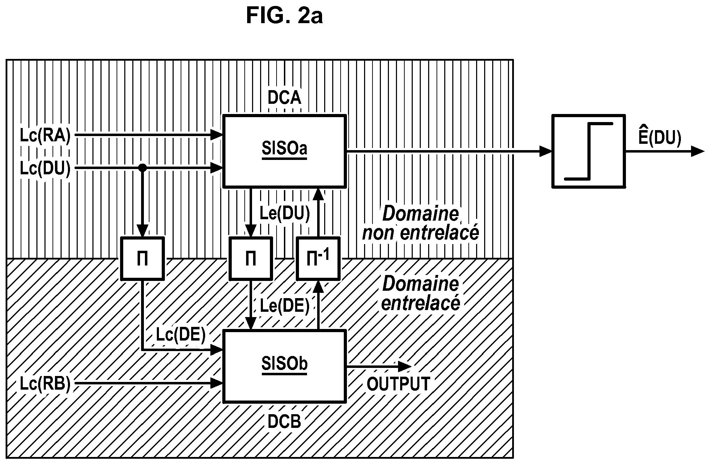

Les turbo-codes correcteurs d'erreurs sont apparus dès 1991 avec le brevet initial de Claude Berrou. Les premières versions utilisées à l'origine étaient des codes convolutifs concaténés en parallèle (PCCC), dont un schéma est représenté en figure 1a. Deux encodeurs élémentaires (encodeur composant) convolutifs (appelés encodeurs composants notés CC) classiques reçoivent les données informatives ou utiles (DU). Le premier encodeur composant (CCA) génère une première redondance de r bits appelée RA alors que le deuxième encodeur composant (CCB) génère une seconde redondance de r' bits appelée RB. Mais auparavant les données utiles ou informatives (DU) sont passées dans un entrelaceur Π qui mélange de façon prédictible et réversible la séquence en données entrelacées (DE) pour l'encodeur CCB. Les données de redondances sont concaténées avec les données systématiques pour former un mot de code parallèle de (k+r+r') bits CP=[DU,RA,RB]. Les redondances peuvent éventuellement être poinçonnées, c'est-à-dire qu'on en laisse tomber une partie, auquel cas la redondance est plus petite. On trouve en figure 2a un décodeur d'un tel code PCCC. Il contient deux décodeurs DCA et DCB respectivement associés à l'encodeur CCA ou CCB car ils sont configurés pour déterminer les données utiles les plus vraisemblablement émises à l'origine en fonction de l'observation des mots de codes reçus du canal. Le décodeur DCA reçoit les observations du canal portant sur les données utiles DU et la première redondance RA, tandis que le décodeur DCB reçoit les observations concernant les données utiles entrelacées DE et la deuxième redondance RB. Chaque décodeur seul ne peut pas trouver la solution. La collaboration des deux décodeurs est nécessaire et consiste en des itérations alternatives de décodage par DCA et DCB qui envoient l'un à l'autre des estimations Le(DU) ou Le(DE) selon qu'on est dans le domaine entrelacé ou non appelées des informations extrinsèques. Ces dernières doivent s'affiner afin de permettre au décodeur PCCC de converger vers la solution la plus vraisemblable car chaque décodeur tient compte les estimations précédentes de l'autre pour établir les siennes.

Un autre type de turbo-code est appelé turbo-code produit. Ces codes disposent les données utiles DU dans une table et codent chaque ligne et colonne selon un code linéaire assez court. Avec n colonnes et p lignes, un codage horizontal de r redondances et vertical de r' redondances, on obtient un tableau de (n+r) colonnes et (p+r') lignes soit une redondance de pr+nr'+rr' pour np données utiles.

### Turbo-codes concaténés en série

Il existe d'autres types de turbo-codes basés sur deux encodeurs composants et une technique d'entrelacement. L'invention porte en particulier sur les turbo-codes convolutifs concaténés en série (en abrégé turbo-code série, en anglais SCCC soit Serial Concatenated Convolutional Codes) qui ont été jusqu'à maintenant moins étudiés. Ils présentent des performances qui approchent la limite de Shannon.

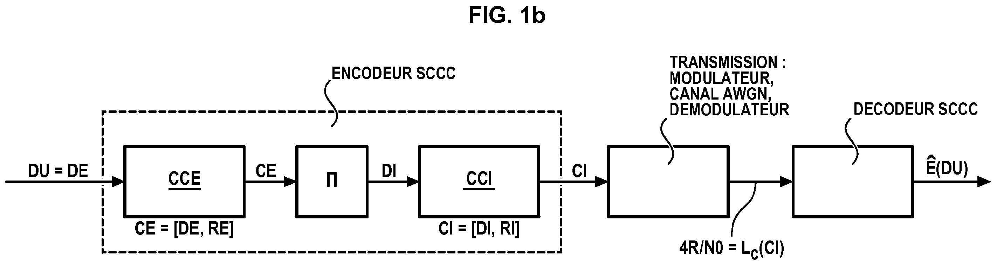

Un turbo-encodeur concaténé de type série comprend deux codes convolutifs disposés en cascade, d'où son nom, comme montré en figure 1b. Ce turbo-encodeur comprend un encodeur convolutif dit externe CCE et un encodeur convolutif dit interne CCI. Le côté externe touche aux données informatives ou utiles, donc à l'extérieur d'une chaîne d'émission et réception, le côté interne touche au canal de propagation, donc à l'intérieur de la chaîne. Les encodeurs sont généralement des codes convolutifs systématiques (RSC en anglais pour Recursive Systematic Code). Un encodeur est dit systématique lorsque les données fournies pour être encodées se retrouvent dans le mot de code de sortie à coté de redondances supplémentaires. Ces données présentes en entrée et en sortie sont alors appelées données systématiques. Un entrelaceur Π est positionné entre la sortie de l'encodeur externe et l'entrée de l'encodeur interne. On en trouve une description dans l'article : S. Benedetto and G. Montorsi, "Serial concatenation of block and convolutional codes, "Electronics Letters, vol. 32, no. 10, pp. 887-888,1996.

Serial concatenation of interleaved convolutional codes forming turbo-like codes, United States Patent US007.116710 B1 , Patent No.: US 7,116,710 B1 Jin et al. Date of Patent: Oct. 3, 2006. https://patents.google.com/patent/US7116710B1/en

Dans l'encodeur SCCC, un mot de données systématiques du code externe appelés données externes DE (ou données utiles DU) comprenant k bits de données informatives ou utiles à transmettre, est encodé par l'encodeur externe CCE pour obtenir un mot de code CE=[DE,RE] comprenant les k bits de données informatives ainsi que r bits de redondance ou de parité appelés données de redondance externe RE. Les bits du mot de code CE sont alors entrelacés par l'entrelaceur **Π** afin d'obtenir le mot de données systématiques du code interne appelées données internes DI comprenant k+r bits de données internes. Comme pour tous les turbo-codes, l'entrelaceur mélange les bits pour éloigner ceux qui sont consécutifs dans le mot de code externe, de façon à maximiser la distance du code concaténé. L'entrelaceur est une opération déterministe réversible. Le mot interne DI est ensuite encodé par l'encodeur interne CCI pour obtenir un mot de code interne CI=[DI,RI] comprenant les k bits de données utiles, les r bits de données de redondance externes, entrelacés en DI et r' bits de redondance supplémentaires ajoutés par l'encodeur interne CCI et appelés données de redondance interne RI.

Le mot CI est alors traduit en symboles émis par un émetteur via un canal vers un récepteur. Celui-ci démodule le signal et reconstitue des symboles bruts reçus R qui sont corrompus, c'est-à-dire qu'ils sont par exemple entachés d'un bruit thermique additif Gaussien (En anglais AWGN, Additive White Gaussian Noise). Aussi, le mot de code R reçu est représentatif du niveau d'énergie du symbole qui transporte le bit codant.

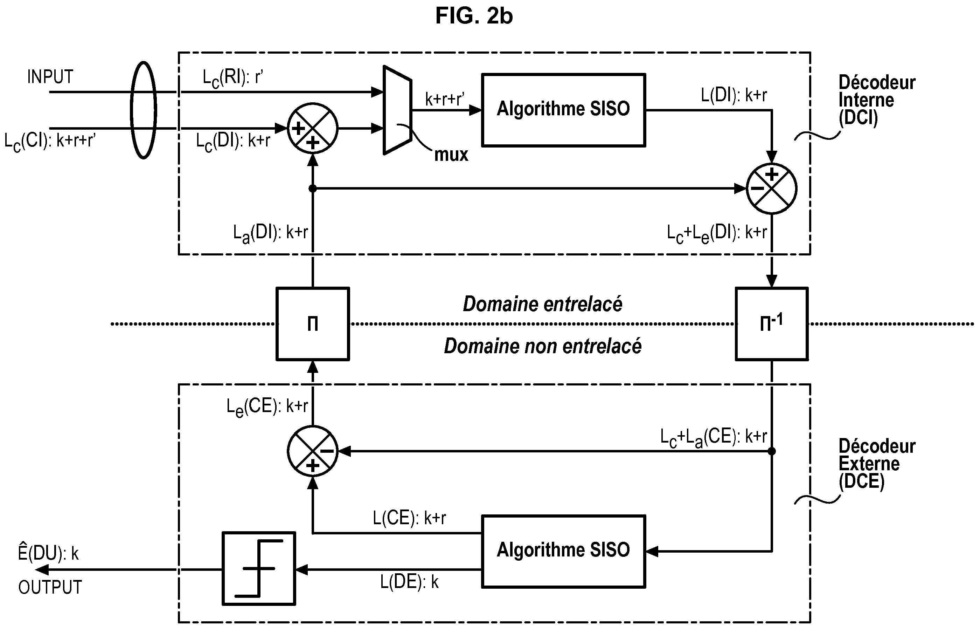

Le décodage est réalisé par un décodeur itératif dont l'état de l'art est illustré sur la figure 2b qui comprend un décodeur interne DCI et un décodeur externe DCE cascadés dans l'ordre inverse de l'encodeur. Le décodeur interne DCI est associé à l'encodeur interne CCI car il détermine les données les plus vraisemblablement encodées par le CCI. Le décodeur externe DCE est associé à l'encodeur externe CCE car il détermine les données les plus vraisemblablement encodées par le CCE. Le décodeur itératif comprend aussi un désentrelaceur **Π⁻¹** pour désentrelacer les éléments échangés du domaine entrelacé, du côté du décodeur interne DCI au domaine non entrelacé, du côté du décodeur externe DCE et un entrelaceur **Π** pour entrelacer à nouveau les éléments échangés dans l'autre sens, du décodeur externe DCE au décodeur interne DCI.

### Entrées et Sorties souples (Soft I/O)

Les décodeurs composants DCE et DCI sont à entrées et sorties souples. Les entrées ou sorties souples sont aussi connues sous l'expression entrées/sorties pondérées ou SISO (*Soft-In Soft-Out* en anglais). Elles quantifient l'estimation du bit avant ou après décodage. Dans la majorité des réalisations, les informations souples prennent la forme d'un ratio de vraisemblance logarithmique (LLR pour *Log-Likelihood-ratio* en anglais). Le signe du LLR indique si le bit le plus probable est 1 ou 0. La valeur absolue représente le ratio de probabilité entre les deux et en vaut précisément son logarithme. Si le LLR vaut 0, la probabilité d'avoir un 0 ou un 1 est identique, donc vaut ½.

On note par la suite L(XX) les LLR des données du turbo-décodeur désignées par XX dans les schémas d'encodeur. Cela signifie bien que le turbo-décodeur ne manipule pas les données binaires telles que le faisait l'encodeur mais une information de probabilité portant sur ces mêmes données, quantifiée par le LLR. Par abus de langage, on peut parler de données dans le turbo-décodeur mais cela désigne en fait de l'information sur ces données, une estimation ou probabilité de type LLR.

Les entrées des décodeurs composants SISO sont constituées, d'une part, des LLR d'information issus du canal, c'est à dire les LLR associés aux symboles R démodulés à partir du signal reçu, aussi désignés comme les informations intrinsèques et notés Lc(XX), et d'autre part, des LLRs associés aux probabilités (ou estimations) à priori, c'est-à-dire caractérisant la statistique d'émission des données, sans considérer l'encodage concerné et notés La(XX). Pour être plus précis, l'information intrinsèque représente un ratio de probabilités conditionnelles, celles de la réception du symbole brut R selon que l'hypothèse de transmission est 1 ou 0. Cette information dépend donc de la statistique de bruit et il est démontré que Lc vaut 4R/No où No est la densité spectrale de bruit reçu dans le cas simple d'émission d'un symbole bipolaire ±s(t) à travers un canal AWGN. La probabilité a priori concerne en principe la statistique d'émission et est considérée indépendante de la statistique du canal. Il en résulte que le ratio de probabilité conditionnelle d'émission est le produit des deux ratios et que son LLR vaut Lc(XX)+La(XX). C'est cette information avant décodage, appelée estimation conditionnelle, qui est donc réellement fournie en entrée des décodeurs composants SISO.

Leurs sorties sont constituées des LLR associées aux probabilités (ou estimations) à postériori L(XX), calculées par l'algorithme de décodage souple utilisé par le décodeur. Concrètement, elles représentent un ratio de probabilité conditionnelle qui tient compte des mots de codes possibles de l'encodage considéré. Si le décodeur DCI ou DCE fournit un LLR à postériori égal au LLR conditionnel Lc(XX)+La(XX), alors l'analyse n'a pas apporté d'information. Aussi, la formule L(XX)=La(XX)+Lc(XX)+Le(XX) permet de définir par soustraction l'information extrinsèque notée Le(XX) comme étant la valeur ajoutée de l'algorithme de décodage souple par le décodeur. Le mécanisme fondamental du décodage turbo est que l'information extrinsèque fournie en sortie par un décodeur est réinjectée comme la probabilité à priori en entrée de l'autre décodeur. Cette disposition tend à faire converger l'algorithme car les estimations faites par l'un tiennent compte des estimations précédemment trouvées par l'autre, en imposant que l'émetteur présentait une probabilité a priori correspondante.

### Fonctionnement du décodeur SCCC

Le décodeur itératif (turbo) doit déterminer les données informatives ou utiles qui étaient le plus vraisemblablement injectées à l'origine dans l'encodeur concaténé en série. Chaque décodeur composant interne ou externe ne peut pas trouver seul la solution. La technique dite « turbo » consiste donc à les faire collaborer en itérant un décodage successif du DCI et du DCE. A chaque exécution, les décodeurs effectuent des calculs de vraisemblance selon leurs entrées souples et mettent à jour leurs estimations des bits des mots de code sous forme de LLR. Ces dernières s'affinent et convergent alors vers la solution la plus vraisemblable car chaque décodeur tient compte des estimations précédentes de l'autre pour établir les siennes. Les mécanismes des décodeurs SCCC ou PCCC sont donc essentiellement semblables.

On détaille ci-après les entrées/sorties de la figure 2b. Le décodeur interne DCI est alimenté en entrée par les LLRs correspondants au mot de code CI généré par l'encodeur interne CCI de (k+r+r') bits. L'entrée de l'algorithme SISO interne est un LLR conditionnel contenant l'information intrinsèque issue de la démodulation du canal Lc(CI) qui constitue l'entrée INPUT du turbo-décodeur, et l'information extrinsèque créée en sortie du décodeur externe Le(CE), entrelacée pour devenir La(DI). Cette information est mise à zéro au début de décodage, lorsqu'on considère que la source de données est équiprobable. Si un poinçonnage a eu lieu, les entrées correspondantes qui ne peuvent pas être observées sur le canal sont également mises à zéro ce qui correspond à une équiprobabilité entre 0 et 1. Comme le mot de code externe CE n'a que (k+r) bits alimentant les données internes DI de l'encodeur CCI, les La(DI) sont alimentés par entrelacement **Π** des informations extrinsèques Le(CE) issues du DCE, quand il n'y a pas de La(RI) correspondant aux r' bits de redondance de l'encodeur interne.

Le décodeur interne DCI génère des probabilités à postériori concernant les données internes L(DI) composées de (k+r) bits. Le DCI calcule les estimations à postériori qui ne concernent que les données systématiques internes mais pas celles concernant les données de redondance car elles ne seront pas transmises au décodeur externe qui ne dispose que de k+r entrées par construction du code. La soustraction du LLR a priori, présenté en entrée, au LLR a posteriori, généré en sortie du DCI, fournit l'information extrinsèque ajoutée à l'information intrinsèque du canal (Lc+Le)(DI) liée aux (k+r) bits de données systématiques du CCI. Elle est transmise au désentrelaceur **Π⁻¹,** devenant ainsi le LLR conditionnel (Lc+La)(CE) en entrée de l'algorithme SISO du décodeur externe, correspondant aux (k+r) bits du mot de code externe. Le décodeur externe DCE génère des probabilités à posteriori concernant le mot de code externe L(CE) et les informations extrinsèques Le(CE) en sont extraites en retranchant l'estimation conditionnelle de l'entrée du DCE. Elles correspondent à k bits de données systématiques externes et r bits de redondance externe et sont rebouclées vers le DCI comme déjà dit.

Lorsque le critère d'arrêt du décodage est atteint, la sortie OUTPUT est constituée d'une décision dure Ê(DU) fournie par le signe du LLR portant sur l'estimation a posteriori des k bits de données externes. Cette estimation est donc extraite du décodeur externe.

Il est notable que les deux décodeurs d'un SCCC sont de nature légèrement différente contrairement à ce qui se passe pour un PCCC. En effet, le décodeur interne ne calcule des informations extrinsèques que sur ses données systématiques DI alors que le décodeur externe doit aussi calculer des informations extrinsèques sur son mot de code CE. Ceci est imposé par la structure concaténée du code SCCC pour lequel les deux encodeurs ne partagent pas la même taille des données systématiques mais une interface de k+r bits qui constituent à la fois le mot de code de l'encodeur externe CCE et les données systématiques de l'encodeur interne CCI. Lorsque l'encodeur externe est systématique, l'estimation a posteriori du mot de code est constituée de celle portant sur ses k données systématiques DE et de celle portant sur ses r bits de redondance RE.

De plus, le DCE est assujetti à une alimentation par les sorties du DCI, libérées selon son rythme de fonctionnement et une séquence rendue pseudo-aléatoire par le désentrelacement intermédiaire. L'absence d'information intrinsèque pure en entrée du DCE ne permet donc pas son exécution pertinente tant que l'information extrinsèque n'est pas libérée par le DCI.

### Décodeur composant en treillis

La représentation en treillis est la manière classique de représenter un code convolutif. A chaque étape k, une donnée d'entrée Dk provoque une transition de l'état courant de l'encodeur Ek vers un autre état Ek+1 ainsi que la création de données de sortie Ck formant le mot de code (un code de ratio ½ fournit 2 bits avec 1 bit d'entrée). Les décodeurs associés exploitent la structure du treillis de codage où les états internes, ou feuilles, sont représentés par des pastilles et les transitions, ou branches, par des flèches les reliant. L'algorithme de décodage en treillis le plus populaire est l'algorithme de Viterbi. Celui-ci recherche le mot de code le plus probable, c'est-à-dire qu'il recherche une solution selon le critère de maximum de vraisemblance (en anglais, ML Maximum Likelihood). La version SOVA (Soft Outputs Viterbi algorithm) peut prendre en compte des probabilités a priori et fournit des LLRs pour chaque bit du mot de code en comparant les métriques au voisinage de la solution optimale du critère ML. Néanmoins, l'algorithme BCJR est un SISO plus performant pour décoder les turbo-codes.

C'est un algorithme de décodage des codes correcteurs d'erreurs définis par un treillis qui fournit une probabilité a posteriori de chaque bit et donc une solution selon le critère de maximum a posteriori MAP. L'algorithme porte le nom de ses inventeurs: Bahl, Cocke, Jelinek et Raviv. Cet algorithme est essentiel pour les codes correcteurs d'erreur modernes décodés itérativement, y compris les turbo-codes et les codes LDPC. Il a été pour la première fois décrit dans: L.Bahl, J.Cocke, F.Jelinek, and J.Raviv, "Optimal Decoding of Linear Codes for minimizing symbol error rate", IEEE Transactions on Information Theory, vol. IT-20(2), pp. 284-287, March 1974.

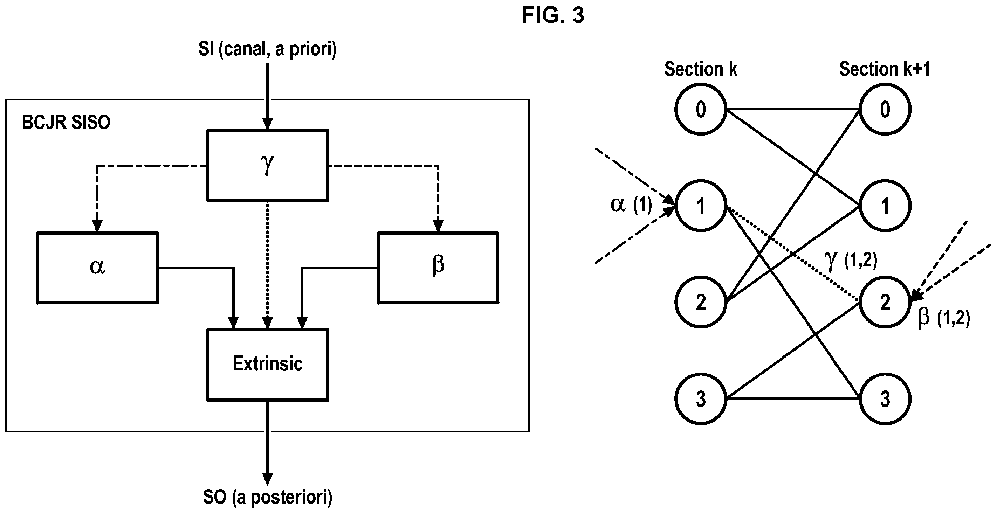

Les principes de cet algorithme sont résumés en figure 3. A l'étape k, c'est-à-dire le passage entre les sections k et k+1 du treillis, il calcule trois métriques : ***γ*** caractérise la transition de l'état Ek à Ek+1 et est fonction des LLRs La(Ck) et Lc(Ck); ***α*** est caractéristique de tous les trajets aboutissant au nœud Ek et ***β*** de tous les trajets partant du nœud Ek+1. L'APP du symbole d'indice k (A Posteriori Probability) qui fournit donc L(Ck) est fonction de la métrique **(*α+β+γ*)** pour toutes les transitions du treillis. La métrique ***α*** est construite par récurrence selon une progression directe (forward, k croissant) à partir des sommes **(*α*+*γ*)** sur les transitions aboutissant aux nœuds d'indice k alors que ***β*** est construit par récurrence selon une progression à rebours (backward, k décroissant) à partir des sommes **(*β*+*γ*)** sur les transitions aboutissant aux nœuds d'indice k+1. En pratique, il faut donc un aller et un retour sur les indices k pour effectuer une exécution du BCJR.

### Durées d'exécution des décodeurs SCCC

Un cycle complet de décodage avec les deux décodeurs DCI et DCE aboutit à la restitution des données utiles ou informatives les plus probables grâce à plusieurs itérations successives.

Une itération se définit comme la durée d'un échange complet dans le sens aller et le sens retour entre les deux décodeurs (interne et externe) d'informations extrinsèques internes et externes relatives à toutes les données du mot à décoder. Une exécution se définit comme la durée de mise à jour de l'ensemble des données extrinsèques en sortie d'un décodeur seul, DCE ou DCI, donc en l'occurrence, un parcours aller-retour du treillis par l'algorithme BCJR.

Un intervalle temporel est le délai élémentaire entre la production de deux informations extrinsèques successives par un décodeur SISO, comme le DCI ou le DCE. Les intervalles temporels ont une durée typique différente pour le DCI et DCE dépendantes de l'architecture matérielle utilisée (CPU, horloge, mémoires, FPGA...). Chaque itération comprend un certain nombre d'intervalles temporels, dépendant du nombre d'informations extrinsèques à échanger par itération.

Les itérations s'arrêtent lorsqu'un critère de convergence est atteint. Le critère est défini de façon à obtenir la certitude que les deux décodeurs composants ont trouvé une solution qui constitue bien un mot de code pour les deux encodeurs internes et externes. Le nombre d'itérations d'un cycle complet est donc essentiellement variable, il peut dépendre du niveau de bruit qui entache les données du canal. Si la durée d'un cycle complet est TC, le décodeur a fourni k bits informatifs en un temps TC et peut dès lors démarrer un nouveau cycle avec un nouveau mot de code. Son débit instantané est donc de k/TC bits/secondes. Son débit moyen dépend de la moyenne du temps de cycle TC et donc du nombre d'itérations moyenne.

Pour garantir un débit minimal au décodeur, on peut lui fixer un nombre maximal d'itérations comme critère d'arrêt supplémentaire de façon à garantir un temps de cycle maximal. Si ce nombre est atteint alors que le critère de convergence n'est pas atteint, la contrepartie est que les données présentent probablement un taux d'erreur supérieur à ce qu'on obtient lorsque le critère est atteint.

Pour augmenter le débit d'un décodeur turbo, on peut s'y prendre de plusieurs manières : la manière la plus triviale consiste à répliquer des décodeurs et à les exécuter en parallèles avec des mots de code consécutifs. Il n'y a aucune inventivité dans un tel dispositif parallèle. Les ressources utilisées (nombre de portes électroniques) sont proportionnelles au nombre de répliques et le temps de cycle est inchangé. Une autre approche consiste à réduire le temps de cycle. On peut tout d'abord réduire l'intervalle temporel élémentaire, ceci revient essentiellement à rechercher un matériel dont la vitesse d'horloge est la plus rapide possible ou dont la cellule élémentaire effectue le plus de calcul en un coup d'horloge, ce qui n'a aucun lien avec la présente invention. On peut ensuite réduire la durée d'exécution d'un décodeur composant. De nombreux travaux sur ce sujet existent.

Enfin, on peut chercher l'architecture et le séquencement d'échange des informations, du canal ou extrinsèques, qui permet de réduire le nombre d'itérations jusqu'à convergence vers le critère. La présente invention propose de tels mécanismes réduisant significativement le temps d'itération.

### Architectures et séquencement des décodeurs turbo.

Dans les schémas d'origine des turbo-décodeurs, chaque décodeur attendait qu'un mot soit décodé intégralement par l'autre décodeur avant d'utiliser ses données extrinsèques. Dans l'architecture la plus simple pour le décodeur PCCC de la figure 2a, il n'y a qu'une seule implémentation physique de décodeur composant. Les deux décodeurs étant généralement similaires, la configuration du décodeur composant en DCA ou DCB ne dépend que de paramètres de configuration. Le décodeur composant alterne donc des exécutions de DCA et de DCB. On peut commencer indifféremment par DCA ou DCB. Une itération dure deux exécutions et les échanges d'informations extrinsèques ont lieu à la fin de chaque exécution. Dans l'architecture de l'état de l'art figure 2b qui représente l'état de l'art du SCCC, comme décrit par E. Boutillon, C. Douillard, and G. Montorsi, "Iterative decoding of Concatenated Convolutional Codes : Implementation Issues", Jan 29th 2007, Proceedings of IEEE, on commence forcément par une première exécution du décodeur interne DCI avant que le décodeur externe DCE ne puisse commencer le premier décodage du mot. Une dépendance existe en effet car le décodeur externe DCE est connecté aux sorties du DCI. La taille du mot de code du DCI est forcément supérieure à celle du DCE à cause de la concaténation en série. Les deux décodeurs composants en série peuvent avoir le même code, mais même dans ce cas, contrairement aux décodeurs PCCCs, ils occupent une quantité de ressources matérielle différente, car le décodeur externe estime à la fois les bits systématiques et les bits de redondance de ses entrées alors que le décodeur interne n'estime seulement que les bits systématiques de ses entrées. De plus, la profondeur du treillis de chacun des deux décodeurs composants en série est différente (taille du mot de code différente), ce qui peut se traduire par une utilisation en ressources mémoires différente. On peut implémenter deux décodeurs séparément, mais alors chacun attend l'autre. Les temps d'attente qui en résultent augmentent le temps de cycle et par conséquent réduisent le débit global de décodage.

Des techniques ont été mises en place pour accélérer les turbo-codes parallèles ou produit comme sur la figure 2a. Dans ces codages, les mots de codes des deux encodeurs CCA et CCB transmettent leurs sorties au canal et aucune n'est injectée dans l'autre, aussi le décodage peut démarrer de façon indifférente par l'un ou l'autre décodeur puisque ceci se traduit par une réception indépendante des mots de codes par les deux décodeurs directement du canal. Une façon connue d'accélérer le décodage est de le paralléliser, comme dans l'article suivant : D. Divsalar and F. Pollara, « Multiple Turbo Codes for Deep-Space communications, JPL TDA Progress Report pp 71-78, May 1995. Dans cet article, les deux décodeurs DCA et DCB sont implémentés séparément, lors de sa première exécution, le DCA décode un premier mot de code et le DCB le deuxième mot de code comprenant les mêmes bits informatifs entrelacés. Donc les deux décodeurs décodent les mêmes bits informatifs mais avec un démarrage diffèrent grâce à l'entrelacement... En pratique, cette technique de décodage s'avère inefficace. En regardant de plus près son fonctionnement, on constate que deux enchaînements de décodage sont réalisés en parallèle (DCA-DCB- DCA... et DCB-DCA-DCB...) sans jamais échanger d'information extrinsèques qu'à la fin d'une itération. Cette technique permet de réduire quelque peu le temps de décodage car l'une des chaînes converge plus vite, mais elle utilise deux fois plus de ressources. Au final, une architecture purement parallèle c'est-à-dire dupliquant les ressources pour traiter deux mots de code différents, sera plus efficace pour augmenter le débit.

Dans la littérature, plusieurs travaux ont été menés afin de réaliser des turbo-décodeurs à haut débit en utilisant différentes techniques de parallélisme. La plupart de la littérature concerne les PCCC de C. Berrou où la mise en pratique du parallélisme est adaptée à la nature parallèle de la concaténation, et peu de contributions sont consacrées aux concaténations en série. Dans l'article : M. Martina, A. Molino, F. Vacca, G. Masera, and G. Montorsi, "Highthroughput implementation of an adaptive serial concatenation turbodecoder,"Journal of Communications Software and Systems, vol. 2, p.252, 04 2017, une architecture parallèle avec 16 décodeurs SISO concurrents a été proposée, basée sur la technique de parallélisme à fenêtres glissantes qui consiste à diviser chaque trame en M sous-blocs et associer chaque sous-bloc à un décodeur SISO proposée dans l'article : Schurgers, F. Catthoor, and M. Engels, "Memory optimization of map turbo decoder algorithms", IEEE Transactions on Very Large Scale Integration (VLSI) Systems, vol. 9, no. 2, pp. 305-312, 2001.). Dans l'article : R. Shoup, "Hardware implementation of a high-throughput 64-ppmserial concatenated turbo decoder," vol. 6311, 08 2006, pp. 63 110S-63 110S, l'implémentation matérielle d'un décodeur SCCC Max Log Map à haut débit pour un canal optique est proposée. Le parallélisme a été introduit à la fois dans les calculs métriques des états dans les décodeurs SISO et en utilisant des fenêtres glissantes. Dans les contributions précédentes, le parallélisme introduit dans les décodeurs SCCC était destiné à accélérer les calculs métriques, mais pas l'échange d'informations extrinsèques qui est crucial pour augmenter encore le débit du décodeur.

La technique de décodage dite « shuffled » proposée dans l'article : Juntan Zhang and M. P. C. Fossorier, "Shuffled iterative decoding", IEEE Transactions on Communications, vol. 53, no. 2, pp. 209-213, 2005 et le Brevet associé US7373585, consiste à accélérer les échanges d'informations extrinsèques entre les décodeurs composants d'un système concaténé. Plus précisément, la technique consiste à créer de multiples répliques de sous-décodeurs. Chacun des sous-décodeurs est appelé «group-shuffled sub-decoder.». Dans chaque group-shuffled sub-decoder les estimations de bits ou de symboles qui sont mises à jour par un décodeur itératif conventionnel sont partitionnées en groupes. Le décodeur utilisant la technique « shuffled » utilise les sorties de ses sous-décodeurs de la manière suivante. Chaque fois qu'un bit ou une valeur de symbole ou un message est mis à jour dans chaque group-shuffled sub-decoder, un certain nombre d'autres valeurs ou messages de bit ou de symbole sont utilisés pour effectuer la mise à jour. Les autres valeurs ou messages de bit ou de symbole sont obtenus en utilisant les estimations fournies par le « group-shuffled sub-decoder » qui a mis à jour le plus récemment ce bit ou cette valeur de symbole ou ce message. L'idée est d'accélérer la convergence du décodage itératif, et donc le débit du décodeur. Le décodage selon la technique « shuffled » a été appliqué sur plusieurs types de décodeurs, comme le suggère Juntan Zhang and M. P. C. Fossorier, pour les codes LDPC et les PCCC. Dans l'article : C. Argon and S. W. McLaughlin, "A parallel decoder for low latency decoding of turbo product codes", IEEE Communications Letters, vol. 6,no. 2, pp. 70-72, 2002, les auteurs présentent une approche de décodage parallèle du Turbo Product Code (TPC) pour augmenter le débit tout en conservant le même taux d'erreur. Cette approche a été généralisée sur les LDPCs et Les PCCCs sous le nom de la technique « Shuffled ». Dans l'article : Y. Lu and E. Lu, "A parallel decoder design for low latency turbo de-coding", Second International Conference on Innovative Computing, Information and Control (ICICIC 2007), 2007, pp. 386-386, les auteurs présentent un algorithme de décodage parallèle pour un décodeur PCCC basé sur le travail présenté dans l'article de Juntan Zhang and M. P. C. Fossorier. Dans l'article : O. Muller, A. Baghdadi, and M. Jezequel, "Exploring parallel processing levels for convolutional turbo decoding", 2006 2nd International Conference on Information Communication Technologies, vol. 2, 2006,pp. 2353-2358, les auteurs explorent et analysent les techniques de parallélisme dans le turbo-décodage parallèle, y compris la technique de décodage « shuffled ». L'algorithme de décodage de type « shuffled » pour SCCC ne semble pas avoir été abordé dans la littérature.

### EXPOSE DE L'INVENTION

L'invention propose de remédier aux inconvénients précités. Elle permet notamment de réduire les périodes d'inutilisation des différents décodeurs et donc de réduire le temps de latence du décodage sans nécessairement augmenter dans la même proportion la ressource matérielle utilisée.

A ce titre, l'invention propose, selon un premier aspect, un turbo-décodeur selon la revendication 1.

Ce turbo-décodeur permet donc au décodeur externe de commencer directement le décodage d'un mot, sans attendre la fin du décodage par le décodeur interne. La vitesse de convergence est donc plus rapide que celle obtenue avec un turbo-décodeur concaténé en série classique.

Des modes de réalisation du turbo décodeur sont définis dans les revendications 2 à 7.

L'invention propose, selon un deuxième aspect, un procédé de turbo-décodage selon la revendication 8.

L'invention propose, selon un troisième aspect un produit programme d'ordinateur selon la revendication 9.

### DESCRIPTION DES FIGURES

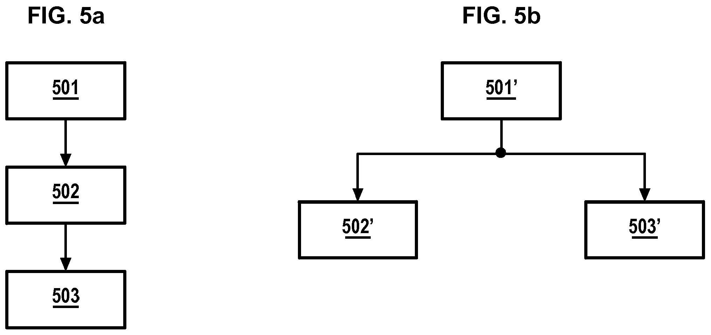

D'autres caractéristiques et avantages de l'invention ressortiront encore de la description qui suit, laquelle est purement illustrative et non limitative et doit être lue en regard des figures annexées sur lesquelles :
[Fig. 1a]
   La figure 1a, décrite précédemment, représente un turbo-encodeur parallèle. Les deux codeurs convolutifs CCA et CCB génèrent chacun une redondance respective RA et RB qui sont concaténées aux données utiles. L'encodeur CCA a ses données systématiques directement alimentées par les données utiles, alors que l'encodeur CCB voit les données utiles entrelacées avant de devenir ses données systématiques.
[Fig. 1b]
   La figure 1b, décrite précédemment, représente un turbo-encodeur série. Les données utiles sont les données systématiques fournies à l'encodeur externe CCE et le mot de code externe CE qu'il génère est entrelacé pour devenir les données systématiques DI fournies à l'encodeur interne CCI. Le mot de code CI généré par l'encodeur interne est l'information transmise par le canal sur des symboles modulés. Ceux-ci sont reçus entachés de bruit, les symboles bruts démodulés R fournissent les informations intrinsèques en entrée du turbo-décodeur SCCC.
[Fig. 2a]
   La figure 2a, décrite précédemment, représente un turbo-décodeur parallèle de l'état de l'art. Le décodeur DCA qui travaille dans le domaine désentrelacé, reçoit les informations intrinsèques du canal, notées Lc(X), concernant les données utiles et la redondance de l'encodeur CCA, quand le décodeur DCB qui travaille dans le domaine entrelacé, reçoit les données intrinsèques du canal concernant les données utiles entrelacées et la redondance de l'encodeur CCB. A chaque itération, le décodeur DCA fournit au décodeur DCB ses informations extrinsèques utiles qu'il faut au préalable entrelacer quand le décodeur DCB fournit au décodeur DCA ses informations extrinsèques entrelacées qu'il convient donc de désentrelacer. Lorsque le turbo-décodeur satisfait les conditions de convergence, les données utiles « dures » sont estimées à partir des informations extrinsèques utiles.
[Fig. 2b]
   La figure 2b, décrite précédemment, représente un turbo-décodeur en série conventionnel. Le décodeur DCI qui travaille dans le domaine entrelacé, reçoit les informations intrinsèques du canal concernant les mots de codes internes CI. A chaque itération, le décodeur DCI fournit au décodeur DCE les estimations conditionnelles qu'il faut désentrelacer de données externes en mot de code externe CE. Réciproquement, à chaque itération, le décodeur DCE qui travaille dans le domaine désentrelacé fournit au décodeur DCI ses informations extrinsèques qu'il convient donc d'entrelacer de mot de code externe en données internes. Les données utiles « dures » E(DU) sont restituées à partir des estimations a posteriori sur les données systématiques externes. A la figure 2b, les entiers associés aux libellés de LLR indiquent le nombre de données associé au flux d'information.
[Fig. 3]
   La figure 3 représente un décodeur selon l'algorithme BCJR avec, à gauche, la cellule de calcule des paramètres ***α, β* et *γ*** pour chaque section du treillis et, à droite, une représentation du treillis passant de l'état #1 pour l'étape k à l'état #2 pour l'étape k+1. La métrique ***α*** caractérise l'ensemble des chemins aboutissant au nœud #1 de l'étape k, la métrique ***γ*** caractérise la transition de l'état #1 vers l'état #2 et la métrique ***β*** caractérise l'ensemble des chemins issus du nœud #2 de l'étape k+1.
[Fig. 4]

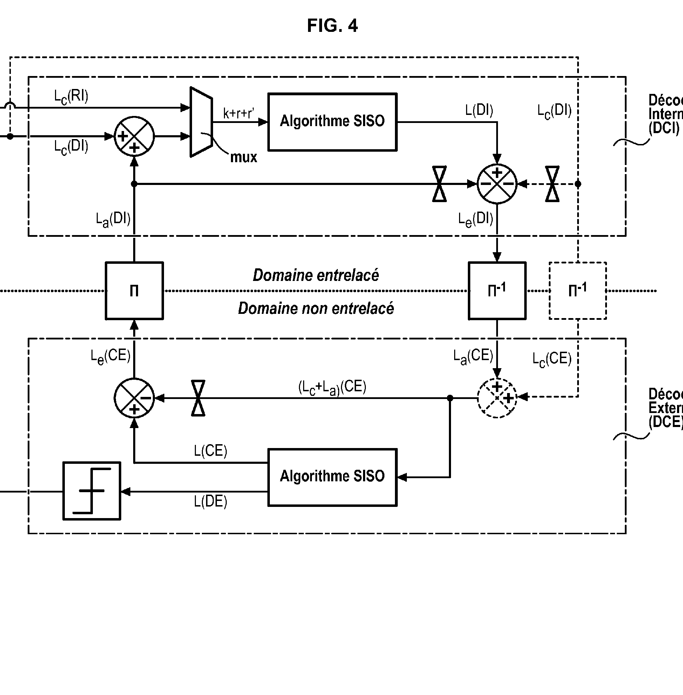

   La figure 4 représente un mode de réalisation du turbo-décodeur série de l'invention. Le dispositif ajouté à celui de la figure 2-b est comme suit. La portion des informations intrinsèques du canal concernant les données systématiques du décodeur interne court-circuite le décodeur interne DCI pour aller alimenter les entrées du décodeur externe DCE. Elles sont au préalable retranchées aux estimations a posteriori fournies par le DCI, ceci afin de ne conserver que des informations extrinsèques. L'estimation conditionnelle externe utilisée en entrée du DCE est alors formée en sommant l'information intrinsèque et a priori portant sur le mot de code externe, obtenue après désentrelacement. La figure 4 affiche un papillon en travers de chaque flèche désignant un flux temporisé pour se synchroniser avec d'autres informations.
[Fig. 5]
   Les flèches de la figure 5 représentent la succession des étapes de traitement. La figure 5-a représente un procédé de turbo-décodage série selon l'état de l'art quand la figure 5-b représente un procédé de turbo-décodage série selon l'invention. Les étapes de décodage du DCI (502 et 502') et du DCE (503 et 503') sont consécutives à l'étape de distribution des informations intrinsèques du canal, mais dans l'invention, l'étape de décodage DCE n'attend pas la fin du décodage DCI.
[Fig. 6]

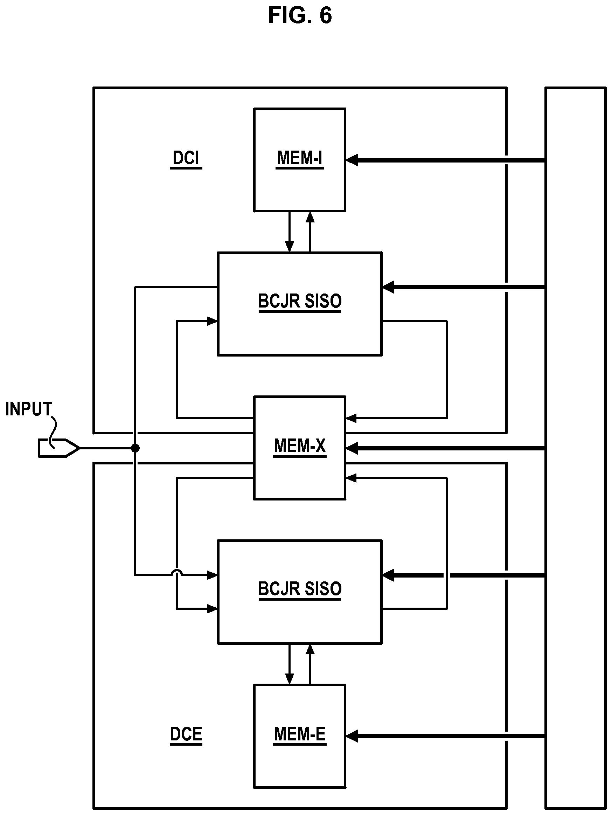

   La figure 6 représente une implémentation du décodeur avec deux décodeurs distincts spécialisés, l'un exécute l'algorithme du DCI quand l'autre exécute l'algorithme du DCE. L'entrée INPUT indique l'arrivée des informations intrinsèques du canal. MEM-X désigne la mémoire d'échange servant à échanger les informations extrinsèques entre les deux décodeurs. MEM-I et MEM-E désignent respectivement les mémoires propres à chaque décodeur, DCI et DCE, pour stocker ses calculs intermédiaires.
[Fig. 7-a]

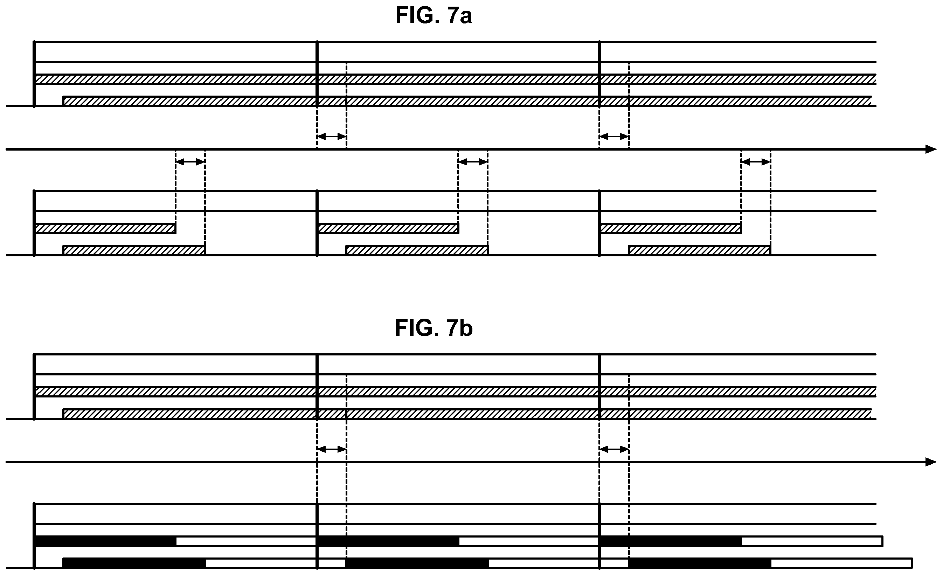

   La figure 7-a représente un chronogramme de fonctionnement du turbo-décodeur série qui n'est pas selon l'invention. Le décodeur interne DCI présente une durée d'exécution qui est deux fois plus longue que celle du décodeur DCE. Aussi, ce dernier attend la fin d'exécution du DCI pour que toutes ses informations extrinsèques mises à jour soient disponibles.
[Fig. 7-b]
   La figure 7-b représente un autre chronogramme de fonctionnement du turbo-décodeur en série de l'invention. Dans ce mode de réalisation, le décodeur externe DCE est relancé une deuxième fois dès qu'il a terminé sa première exécution sans attendre la fin d'exécution du décodeur interne DCI. Ce dernier utilise lors de cette deuxième exécution les dernières informations extrinsèques disponibles.
[Fig. 8-a]
[Fig. 8-b]

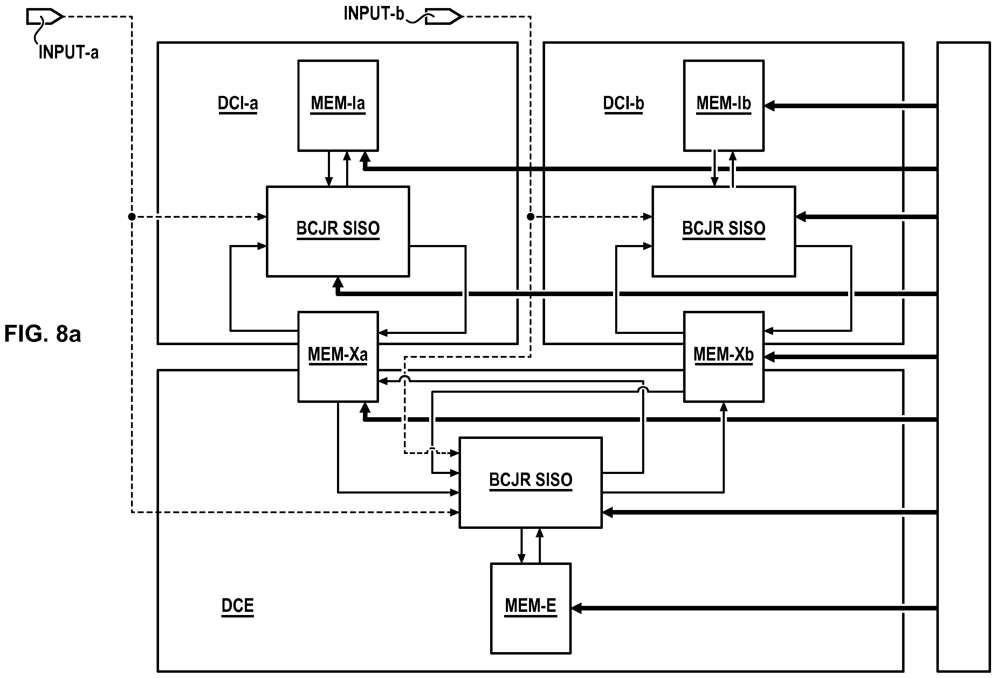

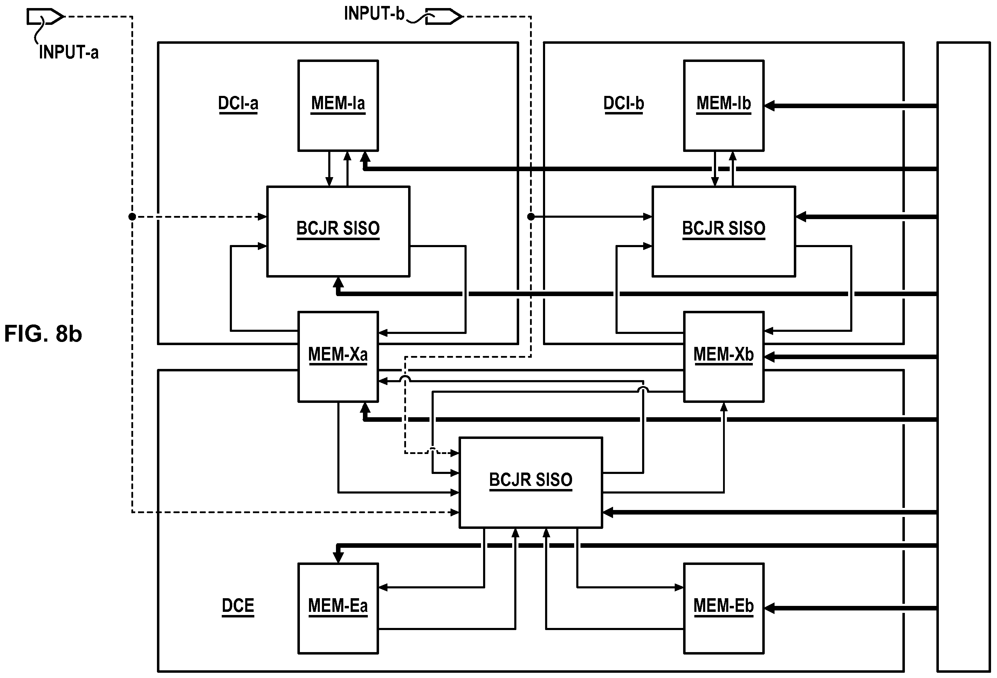

   Les figures 8-a et 8-b représentent un autre mode de réalisation du turbo-décodeur série de l'invention dans laquelle sont implémentés deux décodeurs internes DCI-a et DCI-b qui exécutent l'algorithme de décodage interne et un décodeur externe DCE. INPUT-a et INPUT-b indiquent l'entrée des informations intrinsèques du canal respectivement pour le premier et second mot de code des données transmises. A la figure 8-a Les zones de mémoire MEM-X et MEM-I γ sont dupliquées avec un indice a pour stocker les calculs concernant le premier mot de code et un indice b pour les calculs du second mot de code. Les deux DCI ont accès aux mémoires de leur indice respectifs quand l'unique DCE a accès aux deux indices. A la figure 8-b, la mémoire MEM-E est également dupliquée et chaque instanciation de décodeur DCE accède aux deux indices de zone mémoire pour traiter séparément le premier et le second mot de code.
[Fig. 9-a]
[Fig. 9-b]

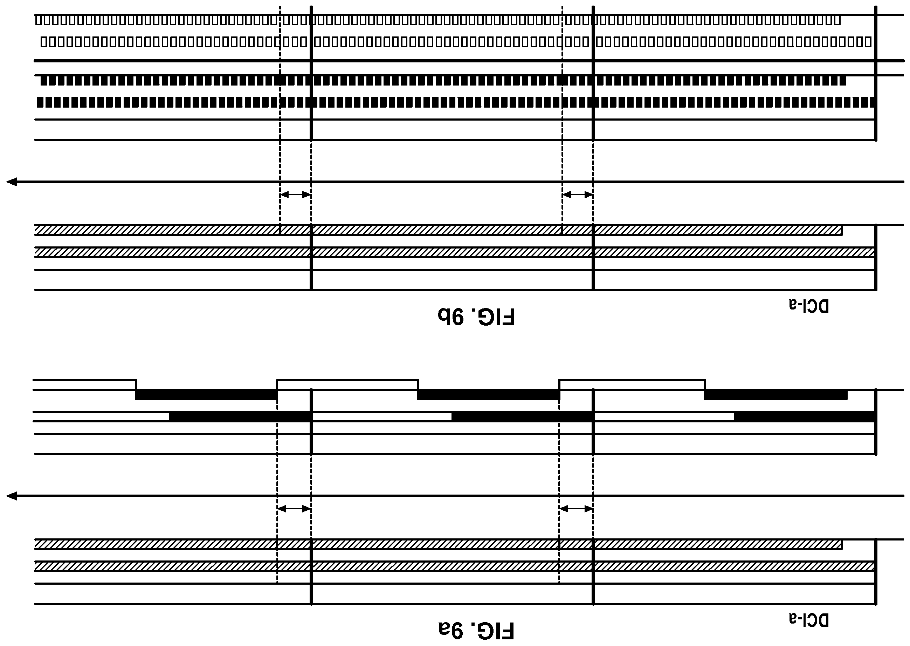

   Les figures 9-a et 9-b représentent chacune un autre chronogramme de fonctionnement du turbo-décodeur série de l'invention, selon les implantations respectives des figures 8-a et 8-b. A la figure 9-a, lors d'une itération, le décodeur DCI-a est exécuté une seule fois pendant que le décodeur DCE est exécuté une première fois en échangeant des informations extrinsèques avec le DCI-a pour le premier mot de code puis une seconde fois en échangeant des informations extrinsèques avec le DCI-b pour le second mot de code. Dans la figure 9b, le DCE est exécuté de façon alternative avec deux instanciations traitant respectivement les informations du premier et du second mot de code, pendant un petit nombre d'intervalles temporels.
[Fig. 10]

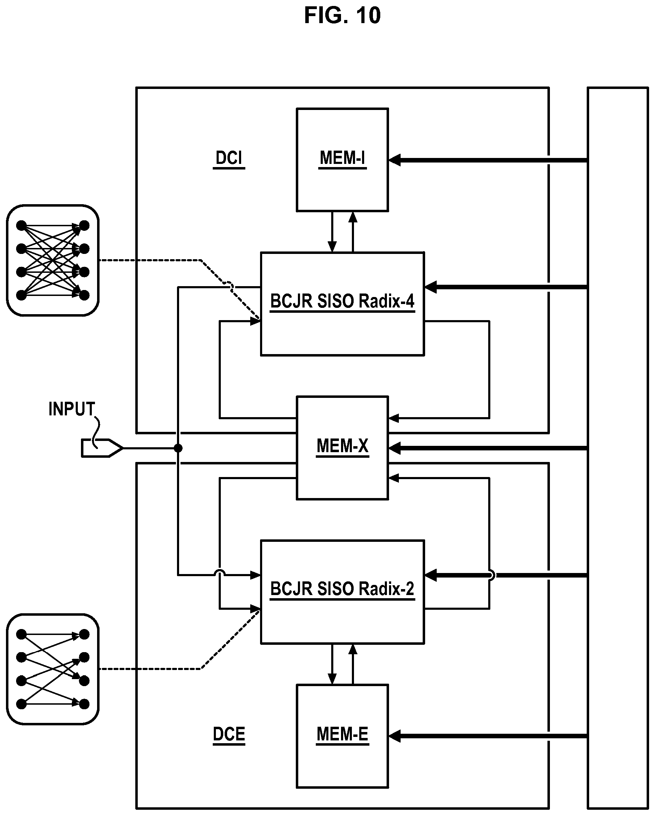

   La figure 10 représente un autre mode de réalisation du turbo-décodeur en série selon l'invention. Ici, le décodeur DCI est configuré pour calculer les métriques de deux transitions d'état successives du treillis en un seul intervalle temporel. Le décodeur DCI est de radix-4 quand le décodeur DCE est de radix-2. Le schéma d'interconnexion de ce turbo-décodeur est le même qu'à la figure 6.
[Fig. 11]

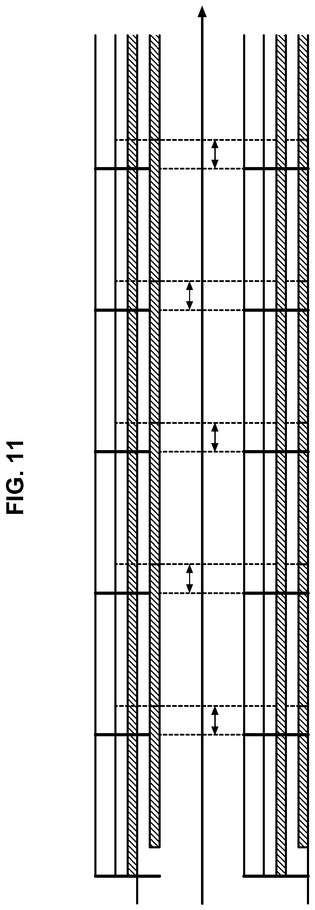

   La figure 11 représente un autre chronogramme de fonctionnement du turbo-décodeur série de l'invention, selon le schéma de la figure 10. Relativement à la figure 7a, la différence est que la durée d'exécution des décodeurs DCE et DCI sont similaires.

### DESCRIPTION DETAILLEE DE L'INVENTION

L'invention se propose d'augmenter le débit et l'efficacité énergétique des décodeurs SCCC en utilisant une technique de décodage du type « shuffled » qui bénéficie avantageusement d'un schéma d'interconnexion permettant de casser la hiérarchie d'alimentation du DCE à travers le DCI, comme décrite précédemment, ainsi que de procédés d'ordonnancement des décodeurs composants permettant de réduire leur période d'inutilisation grâce à un parallélisme de traitement des mots de code.

La figure 1-b représente de manière schématique une chaîne de transmission utilisant un turbo-code en série comme code correcteur d'erreurs (FEC, Forward Error Correction). Les données utiles DU sont encodées par l'encodeur SCC puis transformées en symboles par le modulateur, émises sur le canal bruité, reçues par le récepteur puis démodulées en symboles bruts entachés de bruit. Le dispositif de turbo-décodage série (ou décodeur itératif série) reçoit les données sous la forme d'une trame comprenant une pluralité de mots consécutifs. Typiquement, le turbo-décodeur comprend une unité de traitement comme un processeur pour mettre en œuvre un programme d'ordinateur apte au turbo-décodage série des mots de la trame, ainsi qu'une mémoire pour mémoriser, entre autres, les mots de la trame et des variables intermédiaires nécessaires au turbo-décodage série. Dans un mode de réalisation, l'unité de traitement de données est un circuit logique programmable (réseau logique programmable, FPGA pour *Field-Programmable Gate Array* en anglais) ou un circuit dédié comme un ASIC (pour Application Specific Integrated Circuit en anglais). Ce réseau logique intègre généralement de la mémoire. Dans un autre mode de réalisation, l'unité de traitement est une carte CPU (ou Computer Processing Unit en anglais) qui associe de la mémoire et un processeur multi-cœurs permettant de procéder à plusieurs opérations de calcul en parallèle, ou une carte GPU (en anglais: Graphics Processing Unit) qui utilise un processeur spécialisé pour des traitements graphiques parallélisés.

La mission du turbo-décodeur est de retrouver le mot de code CI transmis par l'émetteur en observant les symboles reçus R entachées d'un bruit qui peut être thermique et de perturbations liées au canal de propagation entre l'émetteur et le récepteur.

Ce mot émis CI comprend k données utiles ou informatives, r données de redondance générées par l'encodeur externe CCE et r' données de redondance générées par l'encodeur interne CCI.

Par mot on comprend une séquence finie de bits, sans donner importance à leur nature (mot de code complet, systématiques, redondances, etc). Ces mots peuvent être concaténés dans une trame de mots successifs.

Dans la suite, on considère que l'encodeur externe CCE présente un rendement 1/n, c'est-à-dire que pour chaque donnée encodée, le mot de code contient n données. Le poinçonnage du mot de code a pour effet de réduire cette valeur qui peut ne plus être entière, mais on considérera par la suite que l'impact de ce poinçonnage ne modifie pas le raisonnement général fait sur le code avant poinçonnage. Le plus souvent, on présente le dispositif dans le cas d'un rendement de 1/2 mais l'homme du métier sait comment modifier le dispositif décrit pour l'adapter à d'autres rendements.

Généralement, les entrées, les sorties et les informations extrinsèques du turbo-décodeur sont des données souples, estimant des probabilités exprimées sous forme de ratio de vraisemblance logarithmique (LLR pour *log-likelihood ratio* en anglais). Cette dénomination est en opposition à des données dures, c'est-à-dire binaires, telles que manipulées par le turbo-encodeur.

Les estimations LLR issues de l'observation des symboles après la démodulation du canal, présentées à l'entrée du turbo-décodeur, sont désignées comme informations intrinsèques. Les informations extrinsèques sont obtenues par soustraction des estimations en entrée du décodeur aux estimations en sortie du décodeur, elles traduisent donc une variation de vraisemblance après l'opération de décodage pour chaque décodeur composant.

La figure 4 représente un turbo-décodeur série selon un mode de réalisation de l'invention, dans lequel il est implémenté sur un FPGA, un circuit dédié ou un processeur. Dans ce mode de réalisation le turbo-décodeur série comprend une entrée INPUT reliée à un décodeur interne DCI et à un décodeur externe DCE, pour que les deux décodeurs puissent recevoir simultanément l'information intrinsèque du canal Lc.

Ainsi, le décodeur interne reçoit l'information intrinsèque Lc(CI) pendant que, via un simple désentrelacement de la partie systématique Lc(DI), le décodeur externe DCE reçoit l'information intrinsèque Lc(CE). Les deux algorithmes SISO de décodage sont ainsi alimentés par l'estimation conditionnelle combinant cette information intrinsèque avec l'information extrinsèque alors disponible en provenance de l'autre décodeur.

Cette modification d'interconnexion du turbo-décodeur série est rendue possible grâce au caractère systématique des codes générés par l'encodeur interne du turbo-encodeur série, c'est-à-dire que celui-ci crée un mot de code interne qui contient le mot de code externe. Le code externe peut ne pas être systématique, sans aucune restriction pour la portée de l'invention. Dans ce cas, le décodeur externe présente une sortie de données utiles DU différente des sorties d'estimations a posteriori portant sur son mot de code. Cependant, en général, chaque encodeur est de type RSC (*Recursive Systematic Code* en anglais).

Durant toutes les itérations et même chaque intervalle temporel, le décodeur externe DCE et l'interne DCI décodent simultanément leur mot de code respectif, afin de générer des estimations a posteriori dont on extrait les informations extrinsèques. Ces informations extrinsèques seront échangées juste après leur production, durant l'itération même, c'est-à-dire qu'on utilise le concept d'échange d'information avec une architecture « shuffled », selon sa signification la plus large.

Durant une itération, le décodeur interne DCI génère k+r informations extrinsèques internes associées aux k+r données systématiques du code interne à partir des k+r+r' informations intrinsèques du canal pour le mot de code interne et des k+r informations extrinsèques externes générées par le DCE durant l'itération en cours ou précédente.

Durant une itération le décodeur externe DCE génère k+r informations extrinsèques externes associées aux k+r données du mot de code externe à partir de k+r informations intrinsèques du canal pour le mot de code externe et des k+r informations extrinsèques internes générées par le DCI durant l'itération en cours ou précédente.

Les k+r informations intrinsèques en entrée du DCE sont obtenues par sélection des informations intrinsèques du canal correspondant aux données systématiques de l'encodage interne DI qu'il faut désentrelacer. On a donc ici laissé tomber les informations intrinsèques de la redondance interne. Par ailleurs, les k+r informations extrinsèques externes, une fois entrelacées, deviennent l'estimation a priori de la partie systématique du code interne. Aussi, le DCI ne dispose pas d'information extrinsèque correspondant à la redondance interne RI. De plus, les k+r informations extrinsèques internes, une fois désentrelacées, deviennent l'estimation a priori du mot de code externe. Aussi, le DCE dispose d'information extrinsèque pour toutes ses données, γ compris la redondance externe.

Avantageusement le décodeur externe DCE et le décodeur interne DCI utilisent un algorithme de décodage du type « maximum à postériori » (MAP pour Maximum A Posteriori en anglais), par exemple en utilisant l'algorithme BCJR (Bahl, Cocke, Jelinek and Ravi du nom des inventeurs), comme présenté à la figure 3. Le décodage calcule des métriques sous forme de LLR à partir de probabilités de transitions d'un nœud d'une section à ceux de la section suivante ou précédente, car le BCJR explore le treillis dans les deux sens. Typiquement, toute implémentation du BCJR permet à l'unité de traitement de calculer les métriques de nœud et de branche en parcourant toutes les branches reliant les nœuds d'une section à ceux de la section suivante ou précédente en un intervalle temporel fixe et relativement court, correspondant à petit nombre de cycles du signal d'horloge qui cadence l'unité de traitement.

Durant chaque intervalle temporel, le décodeur interne DCI investigue une section du treillis de l'encodage interne et génère l'information extrinsèque interne associée aux données systématiques de cette section. Comme, en principe, le treillis de l'encodeur interne traite une donnée systématique par section, il génère une information extrinsèque par intervalle temporel.

Durant chaque intervalle temporel, le décodeur externe DCE investigue une section du treillis de l'encodage externe et génère l'information extrinsèque externe associée aux données du code de cette section. Il en résulte que le DCE génère n informations extrinsèques externes par intervalle temporel et si l'encodeur externe est systématique, l'une d'elles correspond à une donnée systématique quand les n-1 autres correspondent aux données de redondance externe.

La modification d'interconnexion permet au décodeur externe DCE d'être indépendant du décodeur interne DCI et de démarrer son décodage simultanément à celui du décodeur interne DCI. Au schéma 2-b, il devait attendre la fin du décodage de ce dernier et la production de son information extrinsèque interne Le(DI), mais avec l'interconnexion de la figure 4, l'utilisation des données intrinsèques portant sur le mot de code externe durant la première itération rend tout à fait pertinentes les estimations a posteriori produites par le DCE, même lorsque l'information extrinsèque interne est, pour tout ou partie, indisponible à son entrée. Ces informations extrinsèques arrivent au décodeur externe DCE, non seulement plus tardivement, mais aussi selon une séquence très différente de l'arrivée des informations intrinsèques internes correspondantes, puisque le décodeur DCI possède sa propre logique de séquencement pour parcourir le treillis, à la fois dans les sens directs et à rebours. Aussi, les opérations de soustraction de l'information intrinsèque Lc(DI) avant désentrelacement puis de rajout de cette même information intrinsèque Lc(CE) après désentrelacement ne s'annulent pas car elles se passent selon une chronologie très différente. Les papillons de la figure 4 indiquent que les informations intrinsèques seront ultérieurement retranchées lorsque les informations a posteriori internes correspondantes sont disponibles.

Sur la figure 6 le dispositif comprend également :
- une zone mémoire propre interne MEM-I permettant de stocker les variables intermédiaires a et β de l'algorithme BCJR du décodeur interne DCI,
- une zone mémoire propre externe MEM-E permettant de stocker les variables intermédiaires a et β de l'algorithme BCJR du décodeur externe DCE,
- une zone mémoire d'échange MEM-X permettant de stocker les informations extrinsèques internes et externes échangées entre le décodeur interne DCI et le décodeur externe DCE.

La figure 5 représente un procédé de turbo-décodage série selon un aspect de l'invention. La figure 5-a illustre le séquencement pour un décodeur SCCC conventionnel et la figure 5-b le séquencement pour un décodeur SCCC selon l'invention.

Le procédé de turbo-décodage série conventionnel comprend pour chaque itération :
- une étape 501 de réception par le décodeur interne DCI des informations intrinsèques concernant le mot de code CI à décoder,
- une étape 502 de décodage interne permettant de générer, à partir des informations intrinsèques du canal et des informations extrinsèques externes, de nouvelles informations extrinsèques et intrinsèques internes,
- une étape 503 de décodage externe permettant de générer, à partir de la somme des informations extrinsèques et intrinsèques internes, de nouvelles informations extrinsèques externes.

Le procédé de turbo-décodage série selon l'invention comprend pour chaque itération :
- une étape 501' de réception par le décodeur interne DCI et externe DCE des informations intrinsèques concernant respectivement les mots de code CI et CE à décoder,
- une étape 502' de décodage interne permettant de générer, à partir des informations intrinsèques du canal et des informations extrinsèques externes, de nouvelles informations extrinsèques internes,
- une étape 503' de décodage externe permettant de générer, à partir des informations intrinsèques du canal et des informations extrinsèques internes, de nouvelles informations extrinsèques externes.

Les étapes 502 et 502' de décodage interne sont réalisées par le décodeur interne DCI et les étapes 503 et 503' de décodage externe sont réalisées par le décodeur externe DCE. Alors que les étapes 502 et 502' sont formellement identiques, les étapes 503 et 503' diffèrent par leurs informations en entrée. Dans l'architecture conventionnelle, l'étape 503 de décodage externe est forcément successive à l'étape 502 de décodage interne.

En revanche, dans l'architecture de l'invention, L'étape 502' de décodage interne et l'étape 503' de décodage externe débutent simultanément et sont réalisées en parallèle, ce qui permet d'accélérer significativement la rapidité du turbo-décodeur.

Le décodeur externe DCE a une longueur de treillis à décoder inférieure à celles du décodeur interne DCI. En effet, le décodeur interne présente k+r données systématiques qui correspondent à la taille du mot de code à traiter par le décodeur externe. Comme le décodeur externe DCE présente un rendement de 1/n, le décodeur externe DCE aura n fois moins de données systématiques à traiter que le décodeur interne DCI. En supposant, ce qui est l'implémentation usuelle, que le DCE, tout comme le DCI, présentent un treillis présentant une donnée systématique (ou codante si le CCE n'est pas systématique) par section, ils sont de radix-2 pour une donnée binaire. Le décodeur externe DCE utilisera donc n fois moins d'intervalles temporels pour effectuer son décodage que le décodeur interne DCI. Les intervalles temporels étant fondamentalement similaires pour une technologie matérielle donnée, alors l'exécution du DCE va environ n fois plus vite que celle du DCI.

Ainsi, sur la figure 7-a, n vaut 2 et pour chaque itération, le décodeur externe DCE ne réalise un décodage que durant la moitié du temps d'une itération.

L'objectif de l'invention, d'une manière générale, est de faire en sorte que le DCE du décodeur soit toujours utilisé sans avoir à attendre la fin de l'exécution du ou des DCI qui lui sont associés. On a vu que la modification d'interconnexion qui court-circuite le DCI pour alimenter le DCE avec les informations intrinsèques du canal fait sauter le verrou qui limitait la performance d'un turbo-décodeur SCCC conventionnel. Plusieurs stratégies de séquencement sont alors possibles et les modes de réalisation associés sont décrits ci-dessous.

On vient de voir que le DCE présente un temps d'exécution propre qui est environ n fois plus rapide que celui du DCI. Afin d'optimiser le décodage, la figure 7-b représente un mode de réalisation dans lequel le décodeur externe DCE réalise successivement n fois le décodage du même mot sur une même itération, permettant ainsi d'obtenir une information extrinsèque externe plus fiable. Ceci est possible à condition qu'il profite à chaque nouvelle exécution d'informations extrinsèques internes partiellement remises à jour par le DCI au fur et à mesure de son exécution propre. Cette information extrinsèque externe est ensuite utilisée à nouveau par le décodeur interne DCI durant son exécution, dans la même itération ou l'itération suivante. Cette architecture ne peut être avantageuse que pour un turbo-décodeur série car, pour un décodeur parallèle, les temps d'exécutions propres des DCA et DCB sont identiques comme le nombre de sections de leur treillis d'encodage puisqu'ils ont le même nombre de données systématiques (voir figure 2-a). A La figure 7-b, n vaut 2 et le rendement du CCE est ½.

Ainsi, dans cette implémentation, le décodeur externe DCE fonctionne successivement n fois sur la même itération. Cette solution ne nécessite aucun ajout de ressource, elle offre juste une utilisation optimisée de celles déjà disponibles et procure de meilleures performances car elle converge plus rapidement.

Une autre stratégie consiste à dupliquer n fois le décodeur interne DCI pour un seul décodeur DCE implémenté. Chaque décodeur interne DCI reçoit alors un mot à décoder sur n consécutifs et alimente en sortie le même DCE. Les n mots à décoder sont donc traités par le seul décodeur externe DCE dont le temps d'exécution est partitionné selon un ordonnancement choisi.

Les figures 8-a et 8-b représentent ainsi un second mode de réalisation dans lequel n vaut 2 et le rendement est ½. Le décodeur interne DCI est alors doublé, afin que deux mots différents puissent être décodés en parallèle, l'un par le premier décodeur interne DCI-a et l'autre par le deuxième décodeur interne DCI-b.

Dans cette implémentation, l'unique décodeur externe DCE réalise le décodage externe pour les deux décodeurs internes DCI-a et DCI-b.

Le turbo-décodeur série comprend deux entrées INPUT-a et INPUT-b. L'entrée INPUT-a reçoit un premier mot et est reliée au premier décodeur interne DCI-a et au décodeur externe DCE. L'entrée INPUT-b reçoit un deuxième mot et est reliée au deuxième décodeur interne DCI-b et au décodeur externe DCE.

Ce mode de réalisation propose deux niveaux de parallélisme :
- Un parallélisme dans le traitement car le décodage d'un mot est réalisé simultanément par un décodeur interne et un décodeur externe, tout comme dans l'architecture de la figure 6. C'est donc un décodage parallèle concurrentiel.
- un parallélisme supplémentaire des données traitées car deux mots différents sont décodés simultanément grâce à l'utilisation de deux décodeurs internes et un décodeur externe partagé.

Dans ce mode de réalisation, le turbo décodeur série décode simultanément deux mots indépendants en utilisant deux décodeurs internes DCI-a et DCI-b et un seul décodeur externe DCE.

Si l'on revient à un rendement de 1/n, dans un premier sous-mode de réalisation, l'ordonnancement du temps le plus simple consiste à diviser la durée d'une itération complète du DCI en n parties successives égales et à allouer chaque partie au décodage d'un quelconque des n mots. Par exemple, à la figure 9-a, le décodeur externe DCE est utilisé dans la première demi-itération pour décoder le premier mot et dans la deuxième demi-itération pour décoder le deuxième mot.

Ce mode de réalisation nécessite une multiplication des ressources du décodeur interne, γ compris sa zone mémoire propre interne MEM-I, et une multiplication de la taille de la zone mémoire d'échange MEM-X utilisée pour stocker les informations extrinsèques internes et externes, partagées avec l'unique décodeur externe. Cette multiplication est d'un facteur n.

Le dispositif pour n vaut 2 comprend donc :
- une zone mémoire propre externe MEM-E permettant de stocker les variables intermédiaires a et β de l'algorithme BCJR du décodeur externe DCE,
- une zone mémoire propre interne MEM-Ia permettant de stocker les variables intermédiaires a et β de l'algorithme BCJR du premier décodeur interne DCI-a,
- une zone mémoire propre interne MEM-Ib permettant de stocker les variables intermédiaires a et β de l'algorithme BCJR du deuxième décodeur interne DCI-b,
- une zone mémoire d'échange MEM-Xa permettant de stocker les informations extrinsèques internes et externes échangées entre le premier décodeur interne DCI-a et le décodeur externe DCE,
- une zone mémoire d'échange MEM-Xb permettant de stocker les informations extrinsèques internes et externes échangées entre le deuxième décodeur interne DCI-b et le décodeur externe DCE.

Il n'est ici pas nécessaire de multiplier par un facteur n la zone mémoire propre externe utilisée pour stocker les variables intermédiaires a et β utilisées par le décodeur externe, puisque le traitement des mots de code consécutifs est séquentiel et autorise l'écrasement les données du premier mot dont le décodage est terminé quand commence le décodage du second mot. Les ressources dédiées au décodeur DCE, mémoire propre comme unité de calcul, ne sont donc pas augmentées, ce qui constitue un avantage pour l'efficacité de l'implémentation.

La figure 9-a correspondant à l'implémentation de la figure 8-a représente le chronogramme d'activité du fonctionnement du décodeur externe DCE, lorsqu'il utilise la première demi-itération pour décoder le premier mot et utilise la deuxième demi-itération pour traiter le deuxième mot.

Cependant, la figure 8-b représente en fait un second sous-mode de réalisation du turbo-décodeur série pour lequel l'implémentation du décodeur interne DCI est dupliqué. Dans ce sous-mode de réalisation, la zone de mémoire propre externe est également dupliquée en MEM-Ea et MEM-Eb. Ces mémoires sont configurées pour stocker, pour l'une, les variables intermédiaires a et β de l'algorithme BCJR d'une instance du décodeur externe DCE qui décode le premier mot et, pour l'autre, les variables intermédiaires a et β de l'algorithme BCJR d'une autre instance du décodeur externe DCE qui décode le deuxième mot.

Si l'on revient au cas général d'un rendement de 1/n, ce sous-mode nécessite aussi de multiplier par n la zone de mémoire propre externe MEM-E, tout comme le nombre de décodeurs internes DCI et la zone de mémoire d'échange MEM-X l'étaient déjà. Ainsi conçue, cette implémentation permet de décoder simultanément n mots consécutifs, selon un ordonnancement temporel quelconque qui ne nécessite plus d'achever le décodage d'un mot de code avant de commencer le décodage du mot suivant. On dit alors que le décodeur DCE est instancié n fois.

Dans ce mode de réalisation le décodeur externe peut être utilisé à tout instant de la même itération pour décoder n'importe lequel des n mots traités pendant cette itération. Il suffit pour cela, qu'il utilise la portion de mémoire d'échange MEM-X dédiée à ce mot pour l'échange avec le décodeur interne DCI qui est chargé de son décodage ainsi que la portion de mémoire propre externe MEM-E qui γ est également dédiée pour stocker ses métriques et paramètres intermédiaires. Après quelques intervalles temporels, le DCE peut basculer sur le décodage de n'importe quel autre mot de code sans risquer d'écraser de métriques ou d'informations intrinsèques.

Ce sous-mode de réalisation, bien que nécessitant une multiplication supplémentaire de la zone mémoire propre externe du DCE, s'avère présenter l'avantage d'offrir des performances de convergence meilleures que le sous-mode de réalisation précédent. Pour obtenir un tel avantage avec ce sous-mode de réalisation, on peut, par exemple, choisir que le DCE travaillera successivement sur chaque instance de décodage pendant le même petit nombre d'intervalles temporels successifs, avant de passer à l'instance suivante selon une distribution en tourniquet qui fait plusieurs tours, plus connue en anglais sous le terme de « round Robin ». Le chronogramme de ce sous-mode de réalisation est représenté sur la figure 9-b.

Ainsi dans ce mode réalisation, le dispositif avec n vaut 2 tel que représenté à la figure 8-b comprend :
- une zone mémoire propre externe MEM-Ea permettant de stocker les variables intermédiaires a et β de l'algorithme BCJR du décodeur externe DCE pour l'instance qui traite le premier mot de code,
- une zone mémoire propre externe MEM-Eb permettant de stocker les variables intermédiaires a et β de l'algorithme BCJR du décodeur externe DCE pour l'instance qui traite le second mot de code,
- une zone mémoire propre interne MEM-Ia permettant de stocker les variables intermédiaires a et β de l'algorithme BCJR du premier décodeur interne DCI-a qui traite le premier mot de code,
- une zone mémoire propre interne MEM-Ib permettant de stocker les variables intermédiaires a et β de l'algorithme BCJR du deuxième décodeur interne DCI-b qui traite le second mot de code,
- une zone mémoire d'échange MEM-Xa permettant de stocker les informations extrinsèques internes et externes échangées entre le premier décodeur interne DCI-a et l'instance du décodeur externe DCE qui traite le premier mot de code,
- une zone mémoire d'échange MEM-Xb permettant de stocker les informations extrinsèques internes et externes échangées entre le deuxième décodeur interne DCI-b et l'instance du décodeur externe DCE qui traite le second mot de code.

Les deux sous-modes de ce même mode de réalisation utilisent bien la même ressource de calcul consistant en une implémentation de DCE et n de DCI.

La figure 10 représente un mode de réalisation dans lequel le décodeur interne DCI est modifié pour utiliser un algorithme BCJR Radix-4. Un algorithme BCJR Radix-4 traite en une fois deux branches successives du treillis par intervalle temporel, c'est-à-dire qu'il permet dans cette durée de passer de la section k à la section k+2 ou k-2, tandis qu'un algorithme BCJR Radix-2 ne traite qu'une branche du treillis, allant d'une section à la suivante ou précédente, par intervalle temporel. Comme son nom l'indique, chaque nœud de ce treillis possède quatre branches entrantes et quatre branches sortantes au lieu de deux pour un algorithme BCJR de Radix-2, ainsi que le montrent les bulles de la figure 10.

Dans un BCJR de Radix-4, comparativement à un BCJR de Radix-2, le nombre d'étapes est donc divisé par deux comme s'il γ avait deux fois moins de sections puisqu'on les franchit par groupe de deux. Chaque branche de ce treillis correspond donc au traitement d'une hypothèse portant sur deux données systématiques, au lieu d'une à la fois dans l'algorithme BCJR Radix-2. Par conséquent, à la condition de maintenir l'intervalle temporel, la vitesse du décodeur interne DCI sera doublée et la consommation en mémoire des métriques de nœuds dans le décodeur interne DCI sera divisée par deux. Le but recherché est d'accélérer le temps d'exécution du décodeur interne DCI, pour le faire coïncider à celui du DCE. Lorsque le rendement de l'encodeur externe CCE est de ½, alors, le temps d'exécution d'un DCI de radix-4 sera similaire à celui d'un DCE de radix-2.

On revient au cas où le rendement de l'encodeur externe CCE est de 1/n. Lorsque le treillis du décodeur interne traitant une donnée systématique unique à chaque section comporte m branches, alors le DCI le plus élémentaire est de radix-m, ce qui revient à dire que les données internes DI et donc aussi des données du mot de code CI sont d'un alphabet maire. Alors, son temps d'exécution est n fois plus long que celui du DCE le plus élémentaire et il faut agglomérer le traitement de n branches successives pour ramener son temps d'exécution au niveau de celui du DCE. Cela implique qu'on explore n fois m branches possibles, le décodeur interne est donc de radix-mⁿ. Dans le cas usuel, m vaut deux pour des données binaires. Alors, le radix du DCI recherché vaut bien 4 pour un codage CCE de rendement ½ (n=2), comme dans l'exemple de la figure 10.

Plusieurs travaux ont proposée des architectures de décodeurs radix-4 très efficace comme par exemple dans ces articles :
- Y. Zhang and K. K. Parhi, "High-Throughput Radix-4 logMAP Turbo Decoder Architecture," 2006 Fortieth Asilomar Conference on Signals, Systems and Computers, Pacific Grove, CA, 2006, pp. 1711-1715, doi: 10.1109/ACSSC.2006.355053.
- C. Studer, S. Fateh, C. Benkeser and Q. Huang, "Implementation Trade-Offs of Soft-Input Soft-Output MAP Decoders for Convolutional Codes," in IEEE Transactions on Circuits and Systems I: Regular Papers, vol. 59, no. 11, pp. 2774-2783, Nov. 2012, doi: 10.1109/TCSI.2012.2190673.

Ainsi, à la figure 10, les décodeurs internes et externes fonctionnent maintenant avec la même vitesse d'exécution de décodage, comme le montre le chronogramme de la figure 11. Il n'y a plus besoin de dupliquer le DCI ou de relancer le DCE pour que les décodeurs fonctionnent tous en permanence.

Toutefois, pour un rendement de CCE plus petit, donc n plus grand que deux, il est possible que le nombre de branches dépasse le nombre d'états de l'encodeur, ce qui aboutit à une implémentation irréaliste. La réalisation du décodeur DCI de radix-mⁿ suppose également que l'on dispose d'une solution technique pour parcourir ces mⁿ branches successives en une seule fois, au-delà de l'augmentation nécessaire des ressources matérielles pour γ arriver. Une alternative est alors de panacher une solution avec une augmentation de radix à m^{q} avec une solution de duplication de m^{(n-q)} décodeurs DCI conformément au dispositif de la figure 8a ou 8-b, où q est un nombre plus petit que n mais pour lequel l'implantation de l'augmentation de radix-m^{q} demeure aisément réalisable.

## Revendications

1. Turbo-décodeur de turbo code en série SCCC, pour corriger des erreurs dans un mot à décoder, comprenant :
- une entrée (INPUT) configurée pour recevoir le mot à décoder comprenant des informations intrinsèques portant sur des données utiles, et des données de redondance externe et interne,
- un décodeur interne (DCI) configuré pour :
mettre en œuvre un algorithme SISO
effectuer une partie du décodage du mot à partir des informations intrinsèques portant sur les données utiles et les données de redondance interne et externe, et
générer des informations extrinsèques internes à partir des informations extrinsèques externes générées par un décodeur externe en plus des informations intrinsèques qui lui sont fournies;
- le décodeur externe (DCE) étant configuré pour :
mettre en œuvre un algorithme SISO
effectuer une autre partie du décodage du mot à partir des informations intrinsèques portant sur les données utiles et les données de redondance externe , et
générer des informations extrinsèques externes à partir des informations extrinsèques internes en plus des informations intrinsèques qui lui sont fournies;
le décodeur interne (DCI) et le décodeur externe (DCE) étant configurés pour recevoir en parallèle les informations intrinsèques du canal portant sur le mot à décoder au début de chaque cycle de décodage;
le décodeur interne et le décodeur externe étant configurés pour démarrer simultanément une étape de décodage interne et une étape de décodage externe ;
le décodeur externe (DCE) étant configuré pour démarrer l'étape de décodage externe et produire des informations extrinsèques à partir des informations intrinsèques sans attendre la disponibilité d'informations extrinsèques de l'étape de décodage interne (DCI) et le décodeur interne (DCI) étant configuré pour démarrer l'étape de décodage interne et produire des informations extrinsèques à partir des informations intrinsèques sans attendre la disponibilité d'informations extrinsèques de l'étape de décodage externe (DCE).

2. Turbo-décodeur série selon la revendication 1, comprenant en outre :
- une zone mémoire (MEM-E) stockant des variables intermédiaires utilisées par le décodeur externe (DCE),
- une zone mémoire (MEM-I) stockant des variables intermédiaires utilisées par le décodeur interne (DCI) et
- une zone mémoire (MEM-X) stockant les informations extrinsèques internes et les informations extrinsèques externes.

3. Turbo-décodeur série selon l'une des revendication 1 à 2, le décodeur interne (DCI) étant un premier décodeur interne (DCI-a) et l'entrée (INPUT) étant une première entrée (INPUT-a),
le turbo-décodeur série comprenant au moins un deuxième décodeur interne (DCI-b) et une deuxième entrée (INPUT-b) recevant un deuxième mot à décoder envoyé en parallèle au décodeur externe (DCE), qui comprend également des informations intrinsèques portant sur des données utiles, des données de redondance externe et interne,
le premier décodeur interne (DCI-a) étant configuré pour générer des informations extrinsèques internes du premier mot à partir des informations intrinsèques du premier mot et d'informations extrinsèques externes du premier mot et le deuxième décodeur interne (DCI-b) étant configuré pour générer des informations extrinsèques internes du deuxième mot à partir des informations intrinsèques du deuxième mot et d'informations extrinsèques externes du deuxième mot,
le décodeur externe (DCE) étant configuré pour générer des informations extrinsèques externes du premier mot à partir des informations intrinsèques du premier mot et d'informations extrinsèques internes du premier mot et aussi pour générer des informations extrinsèques externes du deuxième mot à partir des informations intrinsèques du deuxième mot et d'informations extrinsèques internes du deuxième mot.

4. Turbo-décodeur série selon la revendication 3, le décodeur externe (DCE) étant configuré pour générer une fois les informations extrinsèques externes du premier mot et les informations extrinsèques externes du second mot lorsque le premier décodeur interne (DCI-a) génère une fois les informations extrinsèques internes du premier mot et le deuxième décodeur interne (DCI-b) génère une fois les informations extrinsèques internes du deuxième mot.

5. Turbo-décodeur série selon la revendication 3 ou 4, comprenant en outre :
- une première zone mémoire (MEM-E) apte à stocker des variables intermédiaires utilisées par le décodeur externe (DCE),
- une deuxième zone mémoire (MEM-Ia) apte à stocker des variables intermédiaires utilisées par le premier décodeur interne (DCI-a),
- une troisième zone mémoire (MEM-Ib) stockant des variables intermédiaires utilisées par le deuxième décodeur interne (DCI-b),
- une quatrième zone mémoire (MEM-Xa) stockant les informations extrinsèques internes du premier décodeur interne et les informations extrinsèques externes pour décoder le premier mot et
- une cinquième zone mémoire (MEM-Xb) stockant les informations extrinsèques internes du deuxième décodeur interne et les informations extrinsèques externes pour décoder le deuxième mot.

6. Turbo-décodeur série selon l'une des revendications 1 à 5, dans lequel les données de l'encodeur interne sont m-aires et le rendement de l'encodeur externe est 1/n avant poinçonnage, où n est entier supérieur ou égal à 2, le décodeur externe (DCE) implémente un algorithme de type Radix-m et le décodeur interne (DCI) implémente un algorithme de type Radix-m^{p}, avec p est un entier inférieur ou égal à n.

7. Turbo décodeur selon la revendication 7 et l'une des revendications 4 à 7 dans lequel un nombre d'instanciations du décodeur interne (DCI) est inférieur à m^{n-p}.

8. Procédé de turbo-décodage de turbo code concaténé en série, SCCC, pour corriger des erreurs dans un mot à décoder comprenant des données utiles et des données de redondance interne et externe, le procédé comprenant :
- une étape (501') de réception des informations intrinsèques par un décodeur externe (DCE) et un décodeur interne (DCI) du mot,
- une étape (502') de décodage interne du mot à partir des informations intrinsèques portant sur les données utiles et des données de redondance interne et externe et
- une étape (503') de décodage externe du mot à partir des informations intrinsèques portant sur les données utiles et des données de redondance externe ;
l'étape de décodage interne (502') étant réalisée par le décodeur interne (DCI) selon un algorithme SISO et générant des informations extrinsèques internes à partir des informations extrinsèques externes générées par le décodeur externe ; l'étape de décodage externe (503') étant réalisée par le décodeur externe (DCE) selon un algorithme SISO et générant des informations extrinsèques externes à partir des informations extrinsèques internes générées par le décodeur interne ; l'étape de décodage interne (502') et l'étape de décodage externe (503') démarrant simultanément,
le décodeur externe (DCE) démarrant à l'étape de décodage externe et produisant des informations extrinsèques à partir des informations intrinsèques sans attendre la disponibilité d'informations extrinsèques de l'étape de décodage interne (DCI) et le décodeur interne (DCI) démarrant l'étape de décodage interne et produisant des informations extrinsèques à partir des informations intrinsèques sans attendre la disponibilité d'informations extrinsèques de l'étape de décodage externe (DCE).

9. Produit programme d'ordinateur comprenant des instructions de code de programme pour l'exécution des étapes du procédé de turbo-décodage série selon la revendication 8, lorsque celui-ci est exécuté par un processeur.

## Patentansprüche

1. Turbodecoder eines seriellen Turbocodes SCCC zur Fehlerkorrektur in einem zu dekodierenden Wort, umfassend:
- einen Eingang (INPUT), der zum Empfangen des zu decodierenden Wortes ausgelegt ist, umfassend intrinsische Informationen über Nutzdaten, und externe und interne Redundanzdaten,
- einen internen Decoder (DCI), der ausgelegt ist, um:
einen SISO-Algorithmus umzusetzen
einen Teil der Dekodierung des Wortes ausgehend von den intrinsischen Informationen über die Nutzdaten und die internen und externen Redundanzdaten durchzuführen, und
interne extrinsische Informationen ausgehend von den externen extrinsischen Informationen zu erzeugen, die von einem externen Decoder erzeugt wurden, zusätzlich zu den intrinsischen Informationen, die ihm bereitgestellt werden;
- wobei der externe Decoder (DCE) ausgelegt ist, um:
einen SISO-Algorithmus umzusetzen
einen anderen Teil der Dekodierung des Wortes ausgehend von den intrinsischen Informationen über die Nutzdaten und die externen Redundanzdaten durchzuführen, und
externe extrinsische Informationen ausgehend von den internen extrinsischen Informationen zusätzlich zu den intrinsischen Informationen zu erzeugen, die ihm bereitgestellt werden;
wobei der interne Decoder (DCI) und der externe Decoder (DCE) ausgelegt sind, um zu Beginn jedes Decodierzyklus parallel die intrinsischen Informationen des Kanals über ein zu decodierendes Wort zu empfangen;
wobei der interne Decoder und der externe Decoder ausgelegt sind, um gleichzeitig einen internen Decodierschritt und einen externen Decodierschritt zu starten;
wobei der externe Decoder (DCE) ausgelegt ist, um den Schritt der externen Decodierung zu starten und um extrinsische Informationen ausgehend von den intrinsischen Informationen zu erzeugen, ohne die Verfügbarkeit extrinsischer Informationen vom internen Decodierschritt (DCI) abzuwarten und der interne Decoder (DCI) ausgelegt ist, um den internen Decodierschritt zu starten und extrinsische Informationen ausgehend von den intrinsischen Informationen zu erzeugen, ohne die Verfügbarkeit extrinsischer Informationen vom externen Decodierschritt (DCE) abzuwarten.

2. Serieller Turbodecoder nach Anspruch 1, der ferner umfasst:
- einen Speicherbereich (MEM-E), der vom externen Decoder (DCE) verwendete Zwischenvariablen speichert,
- einen Speicherbereich (MEM-I), der vom internen Decoder (DCI) verwendete Zwischenvariablen speichert, und
- einen Speicherbereich (MEM-X), der die internen extrinsischen Informationen und die externen extrinsischen Informationen speichert.

3. Serieller Turbodecoder nach einem der Ansprüche 1 bis 2, wobei der interne Decoder (DCI) ein erster interner Decoder (DCI-a) ist und der Eingang (INPUT) ein erster Eingang (INPUT-a) ist,
wobei der serielle Turbodecoder mindestens einen zweiten internen Decoder (DCI-b) und einen zweiten Eingang (INPUT-b) umfasst, der ein zweites, parallel an den externen Decoder (DCE) gesendetes zu decodierendes Wort empfängt, das ebenfalls intrinsische Informationen über Nutzdaten, externe und interne Redundanzdaten umfasst,
wobei der erste interne Decoder (DCI-a) ausgelegt ist, um interne extrinsische Informationen des ersten Wortes ausgehend von den intrinsischen Informationen des ersten Wortes und externen extrinsischen Informationen des ersten Wortes zu erzeugen und der zweite interne Decoder (DCI-b) ausgelegt ist, um interne extrinsische Informationen des zweiten Wortes ausgehend von den intrinsischen Informationen des zweiten Wortes und externen extrinsischen Informationen des zweiten Wortes zu erzeugen,
wobei der externe Decoder (DCE) ausgelegt ist, um externe extrinsische Informationen des ersten Wortes ausgehend von den intrinsischen Informationen des ersten Wortes und internen extrinsischen Informationen des ersten Wortes zu erzeugen und ebenfalls, um externe extrinsische Informationen des zweiten Wortes ausgehend von den intrinsischen Informationen des zweiten Wortes und internen extrinsischen Informationen des zweiten Wortes zu erzeugen.

4. Serieller Turbo-Decoder nach Anspruch 3, wobei der externe Decoder (DCE) ausgelegt ist, um die externen extrinsischen Informationen des ersten Wortes und die externen extrinsischen Informationen des zweiten Wortes einmal zu erzeugen, wenn der erste interne Decoder (DCI-a) einmal die internen extrinsischen Informationen des ersten Wortes erzeugt und der zweite interne Decoder (DCI-b) einmal die internen extrinsischen Informationen des zweiten Wortes erzeugt.

5. Serieller Turbo-Decoder nach Anspruch 3 oder 4, der ferner umfasst:
- einen ersten Speicherbereich (MEM-E), der imstande ist, Zwischenvariablen zu speichern, die von dem externen Decoder (DCE) verwendet werden,
- einen zweiten Speicherbereich (MEM-Ia), der imstande ist, Zwischenvariablen zu speichern, die von dem ersten internen Decoder (DCI-a) verwendet werden,
- einen dritten Speicherbereich (MEM-Ib), der Zwischenvariablen speichert, die von dem zweiten internen Decoder (DCI-b) verwendet werden,
- einen vierten Speicherbereich (MEM-Xa), der die internen extrinsischen Informationen des ersten internen Decoders und die externen extrinsischen Informationen zum Decodieren des ersten Wortes speichert und
- einen fünften Speicherbereich (MEM-Xb), der die internen extrinsischen Informationen des zweiten internen Decoders und die externen extrinsischen Informationen zum Decodieren des zweiten Wortes speichert.

6. Serieller Turbodecoder nach einem der Ansprüche 1 bis 5, wobei die Daten des internen Codierers m-är sind und die Ausbeute des externen Codierers vor dem Punching 1/n beträgt, wobei n eine ganze Zahl größer oder gleich 2 ist, der externe Decoder (DCE) einen Algorithmus vom Typ Radix-m implementiert und der interne Decoder (DCI) einen Algorithmus vom Typ Radix-m^{p} implementiert, wobei p eine ganze Zahl kleiner oder gleich n ist.

7. Turbo-Decoder nach Anspruch 7 und einem der Ansprüche 4 bis 7, wobei eine Instanziierungsanzahl des internen Decoders (DCI) kleiner als m^{n-p} ist.

8. Verfahren zur Turbo-Decodierung eines Serial Concatenated Convolutional Codes, SCCC, zur Fehlerkorrektur in einem zu dekodierenden Wort, das Nutzdaten und interne und externe Redundanzdaten umfasst, wobei das Verfahren umfasst:
- einen Empfangsschritt (501') der intrinsischen Informationen durch einen externen Decoder (DCE) und einen internen Decoder (DCI) des Wortes,
- einen internen Decodierschritt (502') des Wortes ausgehend von den intrinsischen Informationen über die Nutzdaten und interne und externe Redundanzdaten, und
- einen externen Decodierschritt (503') des Wortes ausgehend von den intrinsischen Informationen über die Nutzdaten und externe Redundanzdaten;
wobei der interne Decodierschritt (502') von dem internen Decoder (DCI) gemäß einem SISO-Algorithmus durchgeführt wird und interne extrinsische Informationen ausgehend von den externen extrinsischen Informationen erzeugt, die von dem externen Decoder erzeugt wurden; wobei der externe Decodierschritt (503') von dem externen Decoder (DCE) gemäß einem SISO-Algorithmus durchgeführt wird und externe extrinsische Informationen ausgehend von den internen extrinsischen Informationen erzeugt, die von dem internen Decoder erzeugt wurden; wobei der interne Decodierschritt (502') und der externe Decodierschritt (503') gleichzeitig starten,
wobei der externe Decoder (DCE) beim externen Decodierschritt startet und extrinsische Informationen ausgehend von den intrinsischen Informationen erzeugt, ohne die Verfügbarkeit extrinsischer Informationen aus dem internen Decodierschritt (DCI) abzuwarten und der interne Decoder (DCI) den internen Decodierschritt startet und extrinsische Informationen ausgehend von den intrinsischen Informationen erzeugt, ohne die Verfügbarkeit extrinsischer Informationen aus dem externen Decodierschritt (DCE) abzuwarten.

9. Rechnerprogrammprodukt, das Programmcodeanweisungen zur Ausführung der Schritte des Verfahrens der seriellen Turbodecodierung nach Anspruch 8 umfasst, wenn dieses von einem Prozessor ausgeführt wird.

## Claims

1. Turbo-decoder of turbo code concatenated in series, SCCC, for correcting errors in a word to be decoded comprising:
- an input (INPUT) configured to receive the word to be decoded comprising intrinsic information items pertaining to useful data, external and internal redundancy data,
- an internal decoder (DCI) configured to
implement a SISO algorithm,
carry out a part of the decoding of the word based on the intrinsic information items pertaining to the useful data, and the internal and external redundancy data; and
generating internal extrinsic information items based on the external extrinsic information items generated by an external decoder in addition to the intrinsic information items which are provided to it
- an external decoder (DCE) configured to
implement a SISO algorithm;
carry out another part of the decoding of the word based on the intrinsic information items pertaining to the useful data and the external redundancy data; and
generating external extrinsic information items based on the internal extrinsic information items generated by the internal decoder in addition to the intrinsic information items which are provided to it;
the internal decoder (DCI) and the external decoder (DCE) being configured to receive in parallel the intrinsic information items of the channel pertaining to the word to be decoded at the start of each decoding cycle;
the external decoder (DCE) being configured to start the step of external decoding and produce extrinsic information items based on the intrinsic information items without awaiting the availability of extrinsic information items of the internal decoding step and the internal decoder (DCI) is configured to start the internal decoding step and produce extrinsic information items based on the intrinsic information items without awaiting the availability of extrinsic information items of the external decoding step (DCE).

2. The serial turbo-decoder as claimed in claim 1, further comprising:
- a memory area (MEM-E) storing intermediate variables used by the external decoder (DCE),
- a memory area (MEM-I) storing intermediate variables used by the internal decoder (DCI) and
- a memory area (MEM-X) storing the internal extrinsic information items and the external extrinsic information items.

3. The serial turbo-decoder as claimed in one of claims 1 to 2, the internal decoder (DCI) being a first internal decoder (DCI-a) and the input (INPUT) being a first input (INPUT-a),
the serial turbo-decoder comprising at least a second internal decoder (DCI-b) and a second input (INPUT-b) receiving a second word to be decoded sent in parallel to the external decoder (DCE), which also comprises intrinsic information items pertaining to useful data, and external and internal redundancy data,
the first internal decoder (DCI-a) being configured to generate internal extrinsic information items of the first word based on the intrinsic information items of the first word and on external extrinsic information items of the first word and the second internal decoder (DCI-b) being configured to generate internal extrinsic information items of the second word based on the intrinsic information items of the second word and on external extrinsic information items of the second word,
the external decoder (DCE) being configured to generate external extrinsic information items of the first word based on the intrinsic information items of the first word and on internal extrinsic information items of the first word and also to generate external extrinsic information items of the second word based on the intrinsic information items of the second word and on internal extrinsic information items of the second word.

4. The serial turbo-decoder as claimed in claim 3, the external decoder (DCE) being configured to generate, once, the external extrinsic information items of the first word and the external extrinsic information items of the second word when the first internal decoder (DCI-a) generates, once, the internal extrinsic information items of the first word and the second internal decoder (DCI-b) generates, once, the internal extrinsic information items of the second word.

5. The serial turbo-decoder as claimed in claim 3 or 4, further comprising:
- a first memory area (MEM-E) able to store intermediate variables used by the external decoder (DCE),
- a second memory area (MEM-Ia) able to store intermediate variables used by the first internal decoder (DCI-a),
- a third memory area (MEM-Ib) storing intermediate variables used by the second internal decoder (DCI-b),
- a fourth memory area (MEM-Xa) storing the internal extrinsic information items of the first internal decoder and the external extrinsic information items to decode the first word and
- a fifth memory area (MEM-Xb) storing the internal extrinsic information items of the second internal decoder and the external extrinsic information items to decode the second word.

6. The serial turbo-decoder as claimed in one of claims 1 to 5, wherein the data of the internal encoder are m-ary and the efficiency of the external encoder is 1/n before puncturing, where n is an integer greater than or equal to 2, the external decoder (DCE) implements an algorithm of Radix-m type and the internal decoder (DCI) implements an algorithm of Radix-m^{p}, with p an integer less than or equal to n.

7. The turbo-decoder as claimed in claim 10 and one of claims 4 to 7 wherein a number of instances of the internal decoder (DCI) is less than m^{n-p}.

8. A method for turbo-decoding of turbo code concatenated in series, SCCC, for correcting errors in a word to be decoded comprising useful data, and internal and external redundancy data, the method comprising:
- a step (501') of receiving intrinsic information items by an external decoder (DCE) and an internal decoder (DCI) of the word,
- a step (502') of internal decoding of the word based on the intrinsic information items pertaining to the useful data and internal and external redundancy data and
- a step (503') of external decoding of the word based on the intrinsic information items pertaining to the useful data and the external redundancy data;
the internal decoding step (502') being carried out by the internal decoder (DCI) using a SISO algorithm and generating internal extrinsic information items based on the external extrinsic information items generated by the external decoder, the external decoding step (503') being carried out by the external decoder (DCE) using a SISO algorithm and generating external extrinsic information items based on the internal extrinsic items generated the internal decoder;
the internal decoding step (502') and the external decoding step (503') beginning simultaneously;
the external decoder (DCE) being configured to start the step of external decoding and produce extrinsic information items based on the intrinsic information items without awaiting the availability of extrinsic information items of the internal decoding step and the internal decoder (DCI) is configured to start the internal decoding step and produce extrinsic information items based on the intrinsic information items without awaiting the availability of extrinsic information items of the external decoding step (DCE).

9. A computer program product comprising program code instructions for executing the steps of the serial turbo-decoding method as claimed in claim 8, when the latter is executed by a processor.
